# EUROPÄISCHE PATENTSCHRIFT

(11) **EP 4 176 272 B1**
(45) Veröffentlichungstag und Bekanntmachung des Hinweises auf die Patenterteilung: **13.11.2024**
(21) Anmeldenummer: 21763304.9
(22) Anmeldetag: 13.08.2021
(51) Int. Cl.: G01R 19/155, G07C 3/14

(54) **VERFAHREN ZUM AUTOMATISCHEN ÜBERWACHEN EINES ELEKTROTECHNISCHEN ARBEITSABLAUFS UND ENTSPRECHENDE VORRICHTUNG**
METHOD FOR THE AUTOMATIC MONITORING OF AN ELECTROTECHNICAL WORK FLOW, AND CORRESPONDING DEVICE
PROCÉDÉ DE SURVEILLANCE AUTOMATIQUE D'UN FLUX OPÉRATIONNEL ÉLECTROTECHNIQUE ET DISPOSITIF CORRESPONDANT

(30) Priorität: 14.08.2020 DE 102020210371
(43) Veröffentlichungstag der Anmeldung: 10.05.2023
(73) Patentinhaber: DEHN SE, 92318 Neumarkt i.d. OPf. (DE)
(72) Erfinder: ZIEHMER, Rainer, 92318 Neumarkt (DE); PAULUS, Christian, 92318 Neumarkt (DE); MEIER, Wolfgang, 92318 Neumarkt (DE)
(74) Vertreter: Isarpatent
(86) Internationale Anmeldenummer: PCT/EP2021/072642
(87) Internationale Veröffentlichungsnummer: WO 2022/034230

(56) Entgegenhaltungen:
- WO-A1-2020/161241
- CN-A- 108 656 954
- DE-A1- 102011 104 819
- DE-A1- 102014 218 481
- DE-A1- 102016 104 692
- DE-U1- 9 400 903
- FR-A1- 3 092 230
- SCHÖNIG STEFAN ET AL: "IoT-basiertes Prozessmanagement", INFORMATIK SPEKTRUM, SPRINGER VERLAG, BERLIN, DE, vol. 42, no. 2, 30 January 2019 (2019-01-30), pages 130 - 137, XP036781427, ISSN: 0170-6012, [retrieved on 20190130], DOI: 10.1007/S00287-019-01140-X

## Beschreibung

Die vorliegende Erfindung betrifft ein Verfahren zum automatischen Überwachen eines elektrotechnischen Arbeitsablaufs und eine entsprechende Vorrichtung.

### Stand der Technik

SCHÖNIG STEFAN ET AL: "IoT-basiertes Prozessmanagement", INFORMATION SPEKTRUM, SPRINGER VERLAG, BERLIN, DE, Bd. 42, Nr. 2, 30. Januar 2019 (2019-01-30), Seiten 130-137, XP036781427, ISSN: 0170-6012, DOI: 10.1007/S00287-019-01 140-X offenbart ein Verfahren zum automatischen Überwachen eines Arbeitsablaufs mit einer Mehrzahl von Arbeitsschritten, welches folgende Schritte aufweist: Errichten einer ersten bidirektionalen Kommunikationsverbindung zwischen einem mobilen Kommunikationsgerät und einem Sensor und Starten eines Arbeitsschrittablaufprogramms auf einem mobilen Kommunikationsgerät mittels einer Eingabeeinrichtung des mobilen Kommunikationsgeräts zur Verknüpfung des Sensors mit menschlichen Aufgaben.

Die DE 10 2016 104 692 A1 offenbart ein System und Verfahren zur automatischen Protokollierung der Durchführung eines Arbeitsprozesses, insbesondere Wartungs- oder/und Prüfprozesses. Das System umfasst Sensoreinrichtungen zur Erzeugung für vorgegebene Arbeitsschritte des Arbeitsprozesses repräsentativer Signale sowie Auswerteinrichtungen zum Vergleich der erzeugten Signale mit gespeicherten Sollsignalen und zur Ausgabe von Protokollinformation anhand des Vergleichs.

Die DE 10 2011 104 819 A1 offenbart ein Verfahren zum Betrieb eines Kraftfahrzeughochvoltsystems, bei dem eine Steuer- und/oder Regeleinheit eine Trenneinheit zur Trennung eines ersten Hochvoltbereichs zum Anbinden zumindest eines Elektromotors von einem zweiten Hochvoltbereich zur Anbindung einer Hochvoltspannungsquelle, ansteuert, wobei der erste Hochvoltbereich nach einer über die Trenneinheit erfolgten Freischaltung mittels der Steuer- und/oder Regeleinheit gegen Wiedereinschalten gesichert wird.

Die DE 10 2014 218 096 A1 offenbart ein Verfahren und eine Vorrichtung zur Überwachung eines Fertigungs- und/oder Montageprozesses, wobei der Fertigungs- und/oder Montageprozess zumindest drei Schritte aufweist und mit zumindest einem Sensor je Schritt beobachtet wird und hieraus ein Ergebnis der Überwachung abgeleitet wird.

Obwohl auf beliebige elektrotechnische Arbeitsabläufe anwendbar, bei denen eine mobile Spannungsprüfeinrichtung zum Einsatz kommt, werden die vorliegende Erfindung und die ihr zugrundeliegende Problematik in Bezug auf fünf Sicherheitsregeln bei einem elektrotechnischen Arbeitsablauf zur Wartung von einer Hochspannungsanlage erläutert.

Für die Wartung von einer elektrotechnischen Anlage gibt es fünf Sicherheitsregeln, deren Reihenfolge vom Wartungstechniker strikt eingehalten werden muss. Diese fünf Sicherheitsregeln umfassen die Arbeitsschritte:
1. Freischalten,
2. gegen Wiedereinschalten sichern,
3. Spannungsfreiheit feststellen,
4. Erden und Kurzschließen,
5. benachbarte, unter Spannung stehende Teile abdecken oder abschranken.

Das Freischalten erfolgt in der Regel in Anlagen bis 1 kV durch Ausschalten von Leitungsschutzschaltern, Fehlerstromschutzeinrichtungen, Sicherungslasttrennschaltern, Leistungsschaltern oder durch Herausnehmen von Sicherungseinsätzen oder Trennlaschen mittels NH-Sicherungsaufsteckgriff nach DIN EN 61243-3, mit Stulpe, unter Verwendung von einem Gesichtsschutzschirm und Schutzhelm.

In Anlagen über 1 kV erfolgt das Freischalten durch Ausschalten der Leistungsschalter und der zugehörigen Trennschalter in Schaltanlagen bzw. durch Ausschalten der Lasttrennschalter in Netzstationen.

Alle Schaltgeräte, mit denen die Arbeitsstelle freigeschaltet worden ist, müssen anschließend gegen ein Wiedereinschalten gesichert werden.

Das Freischalten durch Herausnehmen von Sicherungseinsätzen oder einschraubbaren Leitungsschutzschaltern erfolgt, wie gesagt, in Niederspannungsanlagen. Diese Einsätze und/oder Schutzschalter dürfen nicht nur gelockert werden, sondern sie sind vollständig herauszunehmen.

Damit ein unbefugtes Wiedereinschalten verhindert wird, ist die sichere Verwahrung der herausgenommenen Teile vorgeschrieben. Vorteilhaft ist es, anstelle der herausgenommenen Elemente Blindeinsätze oder Schraubkappen einzusetzen, die nur mit besonderem Werkzeug entfernt werden können. In diesem Fall ist das Werkzeug sicher zu verwahren. Fest eingebaute Leitungsschutzschalter müssen im ausgeschalteten Zustand gegen Wiedereinschalten gesichert werden, z.B. durch Sperrstifte, Aufsteckkappen, Klebefolien.

Bei Handantrieben sind abschließbare Sperren zweckmäßig, z.B. Vorhängeschlösser. Bei Schaltgeräten ist der Betätigungsmechanismus zu sperren und Hilfsenergien sind unwirksam zu machen. Bei Handantrieben mit Federkraft ist an geeigneter Stelle ein Bolzen oder Riegel einzuschieben, der die Betätigung des Schalters verhindert. Bei Druckluftantrieben ist die Zuleitung abzusperren und - wegen evtl. undichter Ventile - der Antrieb zu entlüften (z.B. Entfernen der Kappe des Druckluftnotanschlussstutzens). Bei elektrischen Antrieben ist der Betätigungsstromkreis auszuschalten.

Bei speicherprogrammierbaren Steuerungen und rechnergestützten Schalthandlungen muss die Software so gestaltet sein, dass ein unbeabsichtigtes Wiedereinschalten sicher verhindert wird.

Die Spannungsfreiheit muss direkt an der Arbeitsstelle festgestellt werden. Diese Maßnahme deckt auf, wenn:
- beim Freischalten Schalter verwechselt wurden;
- weitere mögliche Einspeisungen übersehen wurden, z.B. Rückspannung, Ersatzstromversorgung, o.ä.;
- der Arbeitende seine Arbeitsstelle verwechselt hat;
- Spannungsverschleppung, z.B. in Verbindung mit unterbrochenem PEN-Leiter, vorliegt.

Die Spannungsfreiheit der freigeschalteten Anlagenteile wird mit einer geeigneten, zumeist mobilen Spannungsprüfeinrichtung festgestellt.

Das Erden und Kurzschließen an der Arbeitsstelle stellt den spannungsfreien Zustand für die Dauer der Arbeiten sicher, auch im Hinblick auf Beeinflussungsspannungen, atmosphärische Überspannungen oder irrtümliches Wiedereinschalten.

Das Erden und Kurzschließen erfolgt durch fest eingebaute Erdungsschaltgeräte nach DIN EN IEC 62271-102 oder zwangsgeführte Staberdungs- und Kurzschließgeräte nach DIN EN 61219 (DIN VDE 0683-200) oder frei geführte ortsveränderliche Erdungs- und Kurzschließgeräte nach DIN EN 61230 (DIN VDE 0683-100).

Anlagenteile in der Nähe der Arbeitsstelle (Annäherungszone), die nicht freigeschaltet werden können, müssen vor Arbeitsbeginn abgedeckt oder abgeschrankt werden, z.B. durch eine Schutzvorrichtung, eine Abdeckung, eine Kapselung oder eine isolierende Umhüllung usw.

Trotz strikter Vorgabe der fünf Sicherheitsregeln kommt es immer noch vereinzelt zu Unfällen aufgrund menschlichen Versagens.

Daher ist es Aufgabe der vorliegenden Erfindung, ein Verfahren zum automatischen Überwachen eines elektrotechnischen Arbeitsablaufs und eine entsprechende Vorrichtung zu schaffen, welche eine erhöhte Sicherheit für den Benutzer bieten.

### Offenbarung der Erfindung

Die vorliegende Erfindung schafft ein Verfahren zum automatischen Überwachen eines elektrotechnischen Arbeitsablaufs nach Anspruch 1 und eine entsprechende Vorrichtung nach Anspruch 23.

Bevorzugte Weiterbildungen sind Gegenstand der jeweiligen Unteransprüche.

### Vorteile der Erfindung

Die der vorliegenden Erfindung zugrunde liegende Idee besteht darin, dass ein Kommunizieren des Prüfergebnisses von der mobilen Spannungsprüfeinrichtung an das mobile Kommunikationsgerät stattfindet und, falls das Prüfergebnis eine Spannungsfreiheit anzeigt, ein automatisches Bestätigen des Überprüfens der Spannungsfreiheit der elektronischen Komponente durch Ausgeben eines Bestätigungssignals durch das mobile Kommunikationsgerät erfolgt, und falls das Prüfergebnis keine Spannungsfreiheit anzeigt, ein Ausgeben eines ersten Alarmsignals durch das mobile Kommunikationsgerät.

Das erfindungsgemäße Verfahren ermöglicht somit eine Erhöhung der Arbeitssicherheit, da der Benutzer nicht nur auf die Anzeige der mobilen Spannungsprüfeinrichtung angewiesen ist, sondern zusätzlich von dem mobilen Kommunikationsgerät gewarnt werden kann, z.B. durch Ausgabe eines akustischen und/oder optischen Signals oder eines Vibrationsalarms.

Gemäß einer bevorzugten Ausführungsform wird eine zweite bidirektionale Kommunikationsverbindung zwischen dem mobilen Kommunikationsgerät und einem zentralen stationären Kommunikationsgerät eingerichtet, wobei das Prüfergebnis von der mobilen Spannungsprüfeinrichtung direkt oder über das mobile Kommunikationsgerät an das zentrale stationäre Kommunikationsgerät kommuniziert wird. So lassen sich Prüfergebnisse zentral erfassen, speichern und zu einem späteren Zeitpunkt zu Kontrollzwecken abrufen.

Gemäß einer weiteren bevorzugten Ausführungsform ist mindestens ein in der mobilen Spannungsprüfeinrichtung speicherbarer Prüfparameter durch das mobile Kommunikationsgerät abfragbar und/oder einstellbar. So läßt sich die Spannungsprüfeinrichtung benutzerspezifisch programmieren und überwachen.

Gemäß einer weiteren bevorzugten Ausführungsform umfasst der Prüfparameter eine akustische oder elektronische Anzeigeeinstellung und/oder eine Zusatzfunktion und/oder einen Nenndatenparameter, insbesondere einen Spannungsmessbereich, und/oder eine Batteriekapazität und/oder einen Prüfpflichtzeitpunkt der Wiederholungsprüfung und/oder eine Betriebsbereitschaft der mobilen Spannungsprüfeinrichtung.

Gemäß einer weiteren bevorzugten Ausführungsform weist das mobile Kommunikationsgerät eine Zeiterfassungseinrichtung auf, wobei das Überprüfen der Spannungsfreiheit der elektronischen Komponente durch die mobile Spannungsprüfeinrichtung zeitmäßig durch das Arbeitsschrittablaufprogramm erfasst und im mobilen Kommunikationsgerät gespeichert wird. So lassen sich Arbeitsschritte mit einem Zeitstempel erfassen und speichern.

Gemäß einer weiteren bevorzugten Ausführungsform weist das mobile Kommunikationsgerät eine GPS-Ortungseinrichtung auf, wobei das Überprüfen der Spannungsfreiheit der elektronischen Komponente durch die Spannungsprüfeinrichtung ortsmäßig durch das Arbeitsschrittablaufprogramm erfasst und im mobilen Kommunikationsgerät gespeichert wird. So lassen sich Arbeitsschritte mit einem zugeordneten Arbeitsort erfassen und speichern.

Gemäß einer weiteren bevorzugten Ausführungsform weist das mobile Kommunikationsgerät eine Wetterprognoseeinrichtung auf, wobei bei Vorliegen einer vorbestimmten Wetterprognose, insbesondere eine Gewitterprognose, einen Warnhinweis im Arbeitsschrittablaufprogramm ausgegeben wird. So kann ein Benutzer auf eine wetterbedingte Gefahrensituation hingewiesen werden.

Gemäß einer weiteren bevorzugten Ausführungsform erfolgt das Bestätigen des Freischaltens der elektronischen Komponente automatisch durch eine mit dem mobilen Kommunikationsgerät kommunikationsmäßig verbundene Freischalt-Bestätigungseinrichtung, wobei bei fehlgeschlagenem Bestätigen ein Ausgeben eines zweiten Alarmsignals durch das mobile Kommunikationsgerät erfolgt und wobei die Freischalt-Bestätigungseinrichtung eine Bilderkennungseinrichtung und/oder eine Schaltzustandsmeldeeinrichtung eines zum Freischalten zu betätigenden Spannungsschalters und/oder eine Elektrolumineszenz-Messeinrichtung zum Messen eines elektrischen Feldes an der elektronischen Komponente aufweist. Dies erhöht die Arbeitssicherheit weiter.

Gemäß einer weiteren bevorzugten Ausführungsform erfolgt nach dem Bestätigen des Freischaltens der elektronischen Komponente und vor dem Ausgeben der Arbeitsschrittanweisung zum Überprüfen der Spannungsfreiheit der elektronischen Komponente ein Ausgeben einer Arbeitsschrittanweisung zum Sichern der elektronischen Komponente gegen ein Wiedereinschalten durch das Arbeitsschrittablaufprogramm und anschließend ein automatisches oder manuelles Bestätigen des Sicherns der elektronischen Komponente gegen ein Wiedereinschalten am mobilen Kommunikationsgerät.

Gemäß einer weiteren bevorzugten Ausführungsform erfolgt das Bestätigen des Sicherns der elektronischen Komponente gegen ein Wiedereinschalten automatisch durch eine mit dem mobilen Kommunikationsgerät kommunikationsmäßig verbundene Wiedereinschaltsicherungs-Bestätigungseinrichtung, wobei bei fehlgeschlagenem Bestätigen ein Ausgeben eines dritten Alarmsignals durch das mobile Kommunikationsgerät erfolgt und wobei die Wiedereinschaltsicherungs-Bestätigungseinrichtung eine Bilderkennungseinrichtung und/oder eine Sperrzustandsmeldeeinrichtung eines zum Wiedereinschaltsichern zu betätigenden Schlosses aufweist. Dies erhöht die Arbeitssicherheit noch weiter. Eine Verriegelung könnte auch softwareseitig erfolgen, wobei gewährleistet sein sollte, dass kein anderer Benutzer während des Arbeitens die Verriegelung mittels eines anderen Gerätes rückgängig machen kann.

Gemäß einer weiteren bevorzugten Ausführungsform erfolgt, falls das Prüfergebnis eine Spannungsfreiheit anzeigt und das Bestätigungssignal von dem mobilen Kommunikationsgerät ausgegeben wird, ein Ausgeben einer Arbeitsschrittanweisung zum Erden und Kurzschliessen der elektronischen Komponente durch das Arbeitsschrittablaufprogramm und anschließend ein automatisches oder manuelles Bestätigen des Erdens und Kurzschliessens der elektronischen Komponente am mobilen Kommunikationsgerät. Auch dies erhöht die Arbeitssicherheit noch weiter.

Gemäß einer weiteren bevorzugten Ausführungsform erfolgt das Bestätigen des Erdens und Kurzschliessens der elektronischen Komponente automatisch durch eine mit dem mobilen Kommunikationsgerät kommunikationsmäßig verbundene Erdungs-/Kurzschluss-Bestätigungseinrichtung, und bei fehlgeschlagenem Bestätigen erfolgt ein Ausgeben eines vierten Alarmsignals durch das mobile Kommunikationsgerät, wobei die Erdungs-/ Kurzschluss-Bestätigungseinrichtung eine Bilderkennungseinrichtung und/oder eine Klemmerfassungseinrichtung zum Erfassen einer Klemmung einer zum Erden und Kurzschliessen verwendeten Klemmeinrichtung (z.B. Drucksensor, Drehmomentsensor, Kraftsensor o.ä.) und/oder eine Einrichtung zum Erfassen von Kugelfestpunkten einer Kugelkopfhaube der Klemmeinrichtung aufweist. Dies erhöht die Arbeitssicherheit noch weiter.

Gemäß einer weiteren bevorzugten Ausführungsform wird nach dem Bestätigen des Erdens und Kurzschliessens der elektronischen Komponente ein Ausgeben einer Arbeitsschrittanweisung zum Sichern und Abschranken benachbarter spannungsführender elektronischer Komponenten durch das Arbeitsschrittablaufprogramm ausgegeben und anschließend ein automatisches oder manuelles Bestätigen des Sicherns und Abschrankens benachbarter spannungsführender elektronischer Komponenten am mobilen Kommunikationsgerät. Dies erhöht die Arbeitssicherheit noch weiter.

Gemäß einer weiteren bevorzugten Ausführungsform erfolgt das Bestätigen des Sicherns und Abschrankens benachbarter spannungsführender elektronischer Komponenten automatisch durch eine mit dem mobilen Kommunikationsgerät kommunikationsmäßig verbundene Sicherungs/Abschrankungs-Bestätigungseinrichtung erfolgt und bei fehlgeschlagenem Bestätigen ein Ausgeben eines fünften Alarmsignals durch das mobile Kommunikationsgerät, wobei die Sicherungs/Abschrankungs-Bestätigungseinrichtung eine Bilderkennungseinrichtung und/oder eine Lageerfassungseinrichtung einer Lage einer zum Sichern und Abschranken verwendeten Barriereeinrichtung aufweist. Dies erhöht die Arbeitssicherheit noch weiter.

Gemäß einer weiteren bevorzugten Ausführungsform wird ein Schutzausrüstungsgegenstand für einen Benutzer vorgesehen, wobei eine dritte bidirektionale Kommunikationsverbindung zwischen dem mobilen Kommunikationsgerät und dem Schutzausrüstungsgegenstand eingerichtet wird und wobei das das mobile Kommunikationsgerät zumindest eines des ersten bis fünften Alarmsignals über die dritte bidirektionale Kommunikationsverbindung an den Schutzausrüstungsgegenstand zum Auslösen einer am Schutzausrüstungsgegenstand angebrachten optischen und/oder akustischen Warneinrichtung und/oder Vibrationsalarmeinrichtung überträgt. So läßt sich die Warneffektivität erhöhen.

Gemäß einer weiteren bevorzugten Ausführungsform weist der Schutzausrüstungsgegenstand eine Schutzjacke und/oder einen Schutzhelm und/oder eine Schutzbrille und/oder einen Schutzmantel und/oder ein Schutzoverall und/oder einen Schaltmantel auf.

Gemäß einer weiteren bevorzugten Ausführungsform weist der Schutzausrüstungsgegenstand einen Vitalsensor auf, wobei die Vitaldaten des Benutzers über die dritte bidirektionale Kommunikationsverbindung an das mobile Kommunikationsgerät übermittelt werden. So lassen sich Gefahrensituationen unmittelbar an ihren Auswirkungen am Körper erkennen.

Gemäß einer weiteren bevorzugten Ausführungsform ist das mobile Kommunikationsgerät eingerichtet, bei übermittelten kritischen Vitaldaten des Benutzers eine vierte uni- oder bidirektionale Kommunikationsverbindung mit einer Rettungszentrale oder Leitwarte aufzubauen. Dies ermöglicht eine schnelle Rettung bei bedrohlichen Situationen.

Gemäß einer weiteren bevorzugten Ausführungsform wird zumindest ein Teil der Arbeitsanweisungen, das zugehörige jeweilige Bestätigen bzw. fehlgeschlagene Bestätigen und das jeweilige Alarmsignal bei fehlgeschlagenem Bestätigen im mobilen Kommunikationsgerät protokolliert und gespeichert.

Gemäß einer weiteren bevorzugten Ausführungsform umfasst das mobile Kommunikationsgerät ein Smartphone oder ein Laptop oder Tablet oder eine Smartbrille oder eine Smartwatch.

Gemäß einer weiteren bevorzugten Ausführungsform ist eine mit dem mobilen Kommunikationsgerät kommunikationsmäßig verbundene Spannungsprüfpunkt-Bestätigungseinrichtung zum Bestätigen des Spannungsprüfpunktes vorgesehen, wobei vor dem Kommunizeren des Prüfergebnisses ein Prüfen des Spannungsprüfpunktes durch die Spannungsprüfpunkt-Bestätigungseinrichtung erfolgt und wobei nur bei erfolgreicher Prüfung das Kommunizeren des Prüfergebnisses von der mobilen Spannungsprüfeinrichtung an das mobile Kommunikationsgerät erfolgt. Dies verhindert Fehlmessungen an einem falschen Spannungsprüfpunkt.

Gemäß einer weiteren bevorzugten Ausführungsform weist die Spannungsprüfpunkt-Bestätigungseinrichtung eine Bilderkennungseinrichtung und/oder eine in der mobilen Spannungsprüfeinrichtung integrierte Sensoreinrichtung auf.

Gemäß einer weiteren bevorzugten Ausführungsform weist der Schutzausrüstungsgegenstand eine Sensoreinrichtung auf, welche ausgestaltet ist, den Zustand, den Gebrauch oder die Wartung des Schutzausrüstungsgegenstandes zu überwachen und über die dritte bidirektionale Kommunikationsverbindung an das zentrale stationäre Kommunikationsgerät zu übertragen.

### Kurze Beschreibung der Zeichnungen

Die vorliegende Erfindung wird nachfolgend anhand der in den schematischen Figuren der Zeichnungen angegebenen Ausführungsbeispiele näher erläutert.

Es zeigen
- Fig. 1: eine Vorrichtung zum automatischen Überwachen eines elektrotechnischen Arbeitsablaufs gemäß einer ersten Ausführungsform der vorliegenden Erfindung;
- Fig. 2: ein Ablaufdiagramm eines Verfahrens zum automatischen Überwachen eines elektrotechnischen Arbeitsablaufs gemäß der ersten Ausführungsform der vorliegenden Erfindung;
- Fig. 3: eine Vorrichtung zum automatischen Überwachen eines elektrotechnischen Arbeitsablaufs gemäß einer zweiten Ausführungsform der vorliegenden Erfindung;
- Fig. 4: ein Ablaufdiagramm eines Verfahrens zum automatischen Überwachen eines elektrotechnischen Arbeitsablaufs gemäß der zweiten Ausführungsform der vorliegenden Erfindung;
- Fig. 5: eine Vorrichtung zum automatischen Überwachen eines elektrotechnischen Arbeitsablaufs gemäß einer dritten Ausführungsform der vorliegenden Erfindung;
- Fig. 6: ein Ablaufdiagramm eines Verfahrens zum automatischen Überwachen eines elektrotechnischen Arbeitsablaufs gemäß der dritten Ausführungsform der vorliegenden Erfindung;
- Fig. 7: eine Vorrichtung zum automatischen Überwachen eines elektrotechnischen Arbeitsablaufs gemäß einer vierten Ausführungsform der vorliegenden Erfindung;
- Fig. 8: ein Ablaufdiagramm eines Verfahrens zum automatischen Überwachen eines elektrotechnischen Arbeitsablaufs gemäß der vierten Ausführungsform der vorliegenden Erfindung;
- Fig. 9: eine Vorrichtung zum automatischen Überwachen eines elektrotechnischen Arbeitsablaufs gemäß einer fünften Ausführungsform der vorliegenden Erfindung;
- Fig. 10: ein Ablaufdiagramm eines Verfahrens zum automatischen Überwachen eines elektrotechnischen Arbeitsablaufs gemäß der fünften Ausführungsform der vorliegenden Erfindung;
- Fig. 11: eine Vorrichtung zum automatischen Überwachen eines elektrotechnischen Arbeitsablaufs gemäß einer sechsten Ausführungsform der vorliegenden Erfindung;
- Fig. 12: ein Ablaufdiagramm eines Verfahrens zum automatischen Überwachen eines elektrotechnischen Arbeitsablaufs gemäß der sechsten Ausführungsform der vorliegenden Erfindung;
- Fig. 13: eine Vorrichtung zum automatischen Überwachen eines elektrotechnischen Arbeitsablaufs gemäß einer siebenten Ausführungsform der vorliegenden Erfindung;
- Fig. 14: eine Spannungsprüfeinrichtung für eine Vorrichtung zum automatischen Überwachen eines elektrotechnischen Arbeitsablaufs gemäß einer achten Ausführungsform der vorliegenden Erfindung; und
- Fig. 15: ein Ablaufdiagramm eines Verfahrens zum automatischen Überwachen eines elektrotechnischen Arbeitsablaufs gemäß der achten Ausführungsform der vorliegenden Erfindung.

### Ausführungsformen der Erfindung

In den Figuren bezeichnen gleiche Bezugszeichen gleiche bzw. funktionsgleiche Elemente.

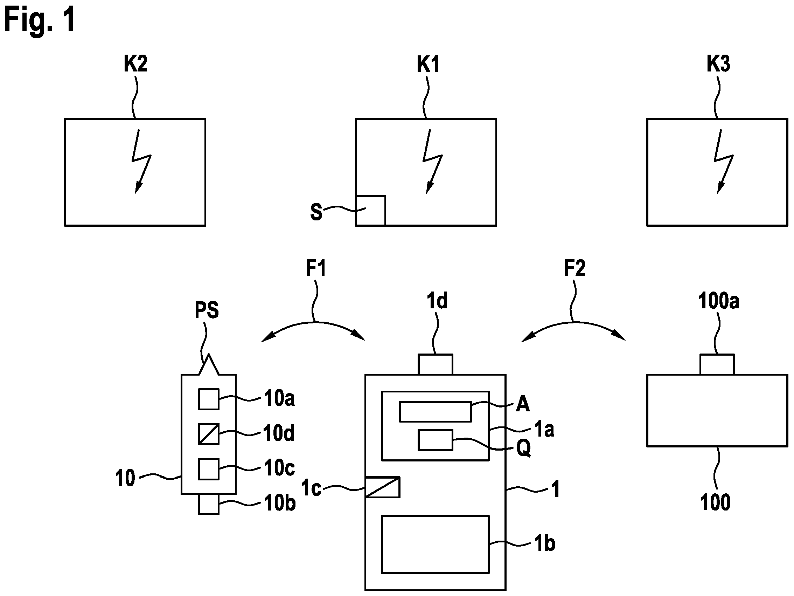

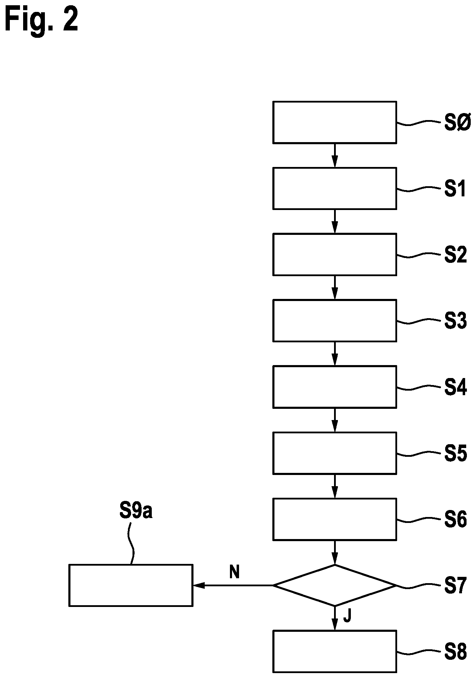

Fig. 1 zeigt eine Vorrichtung zum automatischen Überwachen eines elektrotechnischen Arbeitsablaufs gemäß einer ersten Ausführungsform der vorliegenden Erfindung und Fig. 2 zeigt ein Ablaufdiagramm eines Verfahrens zum automatischen Überwachen eines elektrotechnischen Arbeitsablaufs gemäß der ersten Ausführungsform der vorliegenden Erfindung.

Die Vorrichtung zum automatischen Überwachen eines elektrotechnischen Arbeitsablaufs gemäß Fig. 1 ist ausgestattet mit einem mobilen Kommunikationsgerät 1, welches eine erste Eingabeeinrichtung 1b, eine erste Ausgabeeinrichtung 1a, eine erste Speichereinrichtung 1c und eine erste bidirektionale Kommunikationsschnittstelle 1d aufweist.

Das mobile Kommunikationsgerät 1 ist beispielsweise ein Smartphone oder Laptop-Computer mit einer GSM-Verbindung und einer drahtlosen Übertragungsfunktion (z.B. WLAN-Funktion oder Bluetooth-Funktion oder Mobilfunk-Funktion o.ä.) für die erste bidirektionale Kommunikationsschnittstelle 1d, wobei die erste Eingabeeinrichtung 1b eine Tastatur oder ein Touchscreen und die erste Ausgabeeinrichtung 1a ein Bildschirm sein kann.

In der ersten Speichereinrichtung 1c ist ein Arbeitsschrittablaufprogramm für den elektrotechnischen Arbeitsablauf gespeichert und durch eine entsprechende Benutzereingabe aufrufbar. Das Arbeitsschrittablaufprogramm zeigt dem Benutzer Arbeitsschrittanweisungen A an, welche auszuführen und über ein Bestätigungsfeld Q zu bestätigen sind.

Die Vorrichtung zum automatischen Überwachen eines elektrotechnischen Arbeitsablaufs gemäß Fig. 1 ist weiterhin ausgestattet mit einer mobilen Spannungsprüfeinrichtung 10, welche eine zweite Eingabeeinrichtung 10c, eine zweite Ausgabeeinrichtung 10a, eine zweite Speichereinrichtung 10d und eine zweite bidirektionale Kommunikationsschnittstelle 10b, hier für die drahtlose Übertragungsfunktion, aufweist. Die Spannungsprüfeinrichtung 10 weist eine Prüfspitze PS auf, welche zur Spannungsprüfung an einen vorsehenen Prüfpunkt kontaktierend oder nicht kontaktierend zu setzen ist.

In der zweiten Speichereinrichtung 10d der mobilen Spannungsprüfeinrichtung ist mindestens ein Prüfparameter gespeichert und durch das mobile Kommunikationsgerät 1 über die erste Kommunikationsverbindung F1 abfragbar und/oder einstellbar. Dieser Prüfparameter umfasst z.B. eine akustische oder elektronische Anzeigeeinstellung der zweiten Ausgabeeinrichtung 10a und/oder eine Zusatzfunktion und/oder einen Nenndatenparameter, insbesondere einen Spannungsmessbereich, und/oder eine Batteriekapazität und/oder einen Prüfpflichtzeitpunkt der Wiederholungsprüfung und/oder eine Betriebsbereitschaft der mobilen Spannungsprüfeinrichtung 10.

Durch das Arbeitsschrittablaufprogramm ist eine erste bidirektionale Kommunikationsverbindung F1 zwischen dem mobilen Kommunikationsgerät 1 und der mobilen Spannungsprüfeinrichtung 10 über die erste bidirektionale Kommunikationsschnittstelle 1d und die zweite bidirektionale Kommunikationsschnittstelle 10b einrichtbar.

Eine zweite bidirektionale Kommunikationsverbindung F2 zwischen dem mobilen Kommunikationsgerät 1 und einem zentralen stationären Kommunikationsgerät 100 mit einer dritten bidirektionalen Kommunikationsschnittstelle 100a ist über die erste bidirektionale Kommunikationsschnittstelle 1d und die dritte bidirektionale Kommunikationsschnittstelle 100a einrichtbar, hier ebenfalls als drahtlose Übertragungsfunktion (z.B. WLAN-Funktion bzw. als WLAN/Internet-Funktion). Das zentrale stationäre Kommunikationsgerät 100 ist beispielsweise ein lokaler Anwenderserver oder ein zentraler Provider-Server.

Vorliegend ist der elektrotechnische Arbeitsablauf an einer spannungsführenden elektronischen Komponente K1, beispielsweise einem Verteilerschrank oder bei Schalthandlungen an elektrischen Anlagen (z.B. Niederspannungs- oder Hochspannungsanlagen im Innen- oder Außenbereich oder Frei- bzw. Oberleitungen) durchzuführen, welche einen Spannungsschalter S zum Freischalten, also zum Unterbrechen der Spannungsversorgung der elektronischen Komponente K1 aufweist.

In der Nähe der spannungsführenden elektronischen Komponente K1 sind benachbarte spannungsführende elektronische Komponenten K2, K3, auf die später näher eingegangen wird.

Mit Bezug auf Fig. 1 erfolgt im Schritt S0 ein Initialisieren auf dem mobilen Kommunikationsgerät 1 durch eine entsprechende Eingabe des Benutzers an der ersten Eingabeeinrichtung 1b. Dabei erfolgt ein Errichten der ersten bidirektionalen Kommunikationsverbindung F1 zwischen dem mobilen Kommunikationsgerät 1 und der mobilen Spannungsprüfeinrichtung 10.

Alternativ kann auch eine automatische Verbindung mit anschließender Quittierung durch das mobile Kommunikationsgerät eingerichtet werden.

Optional kann dabei der mindestens eine Prüfparameter durch das mobile Kommunikationsgerät 1 über die erste Kommunikationsverbindung F1 abgefragt und/oder eingestellt werden.

Im Schritt S1 erfolgt ein Starten des Arbeitsschrittablaufprogramms auf einem mobilen Kommunikationsgerät 1 mittels einer weiteren Eingabe des Benutzers an der ersten Eingabeeinrichtung 1b des mobilen Kommunikationsgeräts 1.

Anschließend erfolgt im Schritt S2 ein Ausgeben S2 einer Arbeitsschrittanweisung A zum Freischalten der spannungsführenden elektronischen Komponente K1 zum Bewirken einer Spannungsfreiheit der elektronischen Komponente K1, z.B. durch Ändern der Schaltstellung des Spannungsschalters S oder eines entsprechenden Softwareschalters über die drahtlose Verbindungsfunktion, auf der ersten Ausgabeeinrichtung 1a des mobilen Kommunikationsgeräts 1 durch das Arbeitsschrittablaufprogramm.

Nach Ausführen des Freischaltens erfolgt dann in Schritt S3 ein manuelles Bestätigen S3 des Freischaltens der elektronischen Komponente K1 am mobilen Kommunikationsgerät über eine Eingabe des Benutzers am Bestätigungsfeld Q.

Nach dem Bestätigen des Freischaltens der elektronischen Komponente K1 in Schritt S3 erfolgt in Schritt S4 ein Ausgeben einer weiteren Arbeitsschrittanweisung A zum Überprüfen der Spannungsfreiheit der elektronischen Komponente K1 mittels der mobilen Spannungsprüfeinrichtung 10 auf der ersten Ausgabeeinrichtung 1a des mobilen Kommunikationsgeräts 1 durch das Arbeitsschrittablaufprogramm.

Der Benutzer führt dann in Schritt S5 das Überprüfen der Spannungsfreiheit der elektronischen Komponente K1 mittels der mobilen Spannungsprüfeinrichtung 10 durch, indem er die Prüfspitze PS zur Spannungsprüfung an den vorsehenen Prüfpunkt setzt und die Spannungsmessung auslöst, z.B. durch Niederdrücken einer entsprechenden Taste der zweiten Eingabeeinrichtung 10c.

Alternativ wird die Spannungsprüfeinrichtung 10 nach dem Einschalten automatisch ggfs. nach einem Selbsttest in den Messzustand versetzt.

Im Anschluss daran erfolgt in Schritt S6 ein Kommunizieren S6 des Prüfergebnisses von der mobilen Spannungsprüfeinrichtung 10 an das mobile Kommunikationsgerät 1 über die erste bidirektionale Kommunikationsverbindung F1.

In Schritt S7 wird das Prüfergebnis von dem Arbeitsschrittablaufprogramm des mobilen Kommunikationsgeräts 1 überprüft.

Falls das Prüfergebnis eine Spannungsfreiheit anzeigt (J in Schritt S7), erfolgt in Schritt S8 ein automatisches Bestätigen des Überprüfens der Spannungsfreiheit der elektronischen Komponente K1 durch Ausgeben eines Bestätigungssignals durch das mobile Kommunikationsgerät, was ggfs. die Ausgabe einer weiteren Arbeitsschrittanweisung A oder das Beenden des Arbeitsschrittablaufprogramms bewirkt.

Falls das Prüfergebnis keine Spannungsfreiheit anzeigt (N in Schritt S7), erfolgt in Schritt S9a ein Ausgeben eines ersten Alarmsignals durch das mobile Kommunikationsgerät 1 über die erste Ausgabeeinrichtung 1a, z.B. in Form eines optischen und/oder akustischen Signals und die mögliche Ausgabe einer weiteren Arbeitsschrittanweisung A wird verhindert.

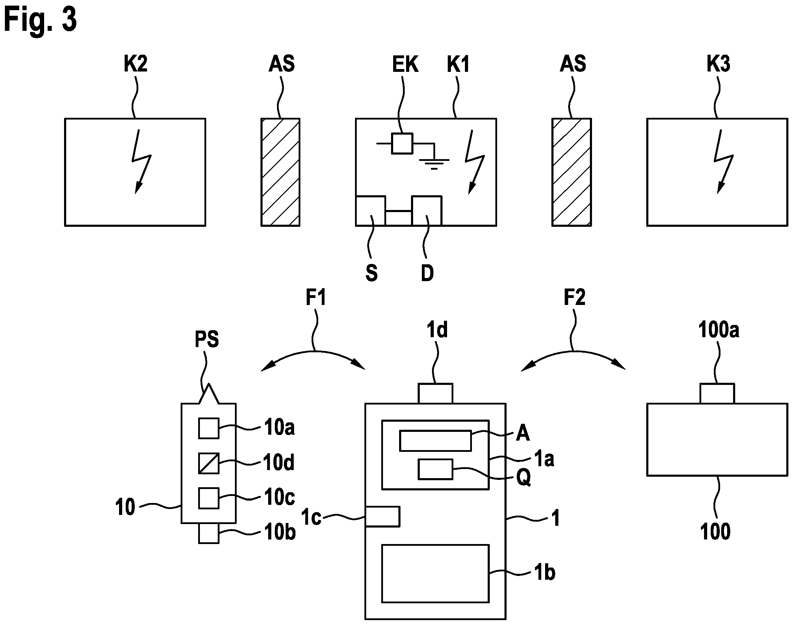

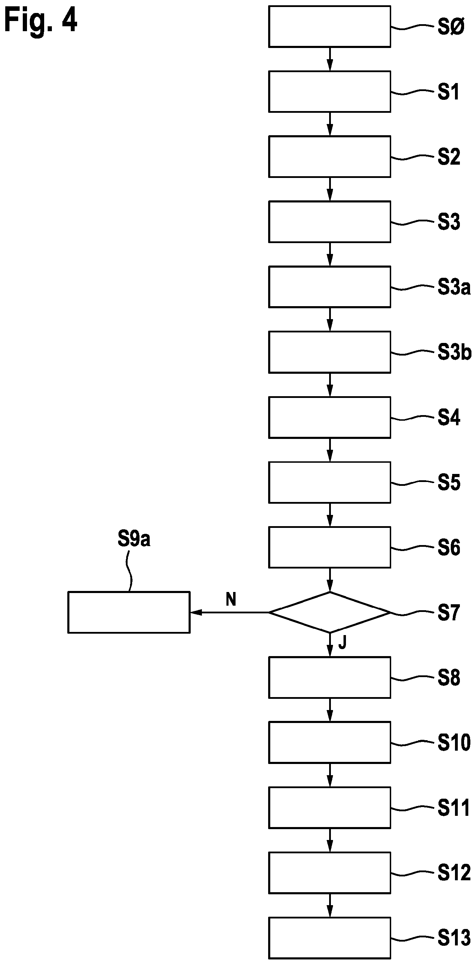

Fig. 3 zeigt eine Vorrichtung zum automatischen Überwachen eines elektrotechnischen Arbeitsablaufs gemäß einer zweiten Ausführungsform der vorliegenden Erfindung, und Fig. 4 zeigt ein Ablaufdiagramm eines Verfahrens zum automatischen Überwachen eines elektrotechnischen Arbeitsablaufs gemäß der zweiten Ausführungsform der vorliegenden Erfindung.

Die Vorrichtung zum automatischen Überwachen eines elektrotechnischen Arbeitsablaufs gemäß Fig. 3 unterscheidet sich von der Vorrichtung gemäß Fig. 1 dadurch, dass die der elektronische Komponente K1 eine Sicherungseinrichtung zum Sichern der elektronischen Komponente K1 gegen ein Wiedereinschalten aufweist, welche beim vorliegenden Beispiel ein stationäres oder mobiles Schloss D ist, und von dem Benutzer im Rahmen des Arbeitsablaufs zu betätigen ist.

Weiterhin sind vom Benutzer eine Klemmeinrichtung EK zum Erden und Kurzschliessen der elektronischen Komponente K1 und eine Barriereeinrichtung AS zum Sichern und Abschranken der benachbarten spannungsführenden elektronischen Komponenten K2, K3 anzubringen.

Gemäß Fig. 4 werden zunächst die Schritte S0 bis S3 derart durchgeführt, wie oben im Zusammenhang mit der ersten Ausführungsform beschrieben.

Nach dem Bestätigen des Freischaltens der elektronischen Komponente K1 im Schritt S3 und vor dem Ausgeben der Arbeitsschrittanweisung A zum Überprüfen der Spannungsfreiheit der elektronischen Komponente K1 im Schritt S4 werden bei der zweiten Ausführungsform zusätzlich die Schritte S3a und S3b durchgeführt.

In Schritt S3a erfolgt ein Ausgeben S3a einer Arbeitsschrittanweisung A zum Sichern der elektronischen Komponente K1 gegen ein Wiedereinschalten durch das Arbeitsschrittablaufprogramm, wobei vorliegend das Schloss D vom Benutzer zu verwenden ist.

Nach dem Sichern der elektronischen Komponente K1 gegen ein Wiedereinschalten erfolgt in Schritt S3b ein manuelles Bestätigen S3b des Sicherns der elektronischen Komponente K1 gegen ein Wiedereinschalten am mobilen Kommunikationsgerät 1 über eine Eingabe des Benutzers am Bestätigungsfeld Q.

Danach werden die Schritte S4 bis S8 bzw. S4 bis S9a durchgeführt, wie bereits oben beschrieben.

Falls das Prüfergebnis eine Spannungsfreiheit anzeigt und das Bestätigungssignal von dem mobilen Kommunikationsgerät 1 in Schritt S8 ausgegeben wird, erfolgt in Schritt S10 ein Ausgeben S10 einer Arbeitsschrittanweisung A zum Erden und Kurzschliessen der elektronischen Komponente K1 durch das Arbeitsschrittablaufprogramm, wobei vorliegend vom Benutzer die Klemmeinrichtung EK zu verwenden ist.

Nach dem Erden und Kurzschliessen der elektronischen Komponente K1 erfolgt in Schritt S11 ein manuelles Bestätigen des Erdens und Kurzschliessens der elektronischen Komponente K1 am mobilen Kommunikationsgerät 1 über eine Eingabe des Benutzers am Bestätigungsfeld Q.

Nach dem Bestätigen des Erdens und Kurzschliessens der elektronischen Komponente K1 in Schritt S11 erfolgt ein Ausgeben S12 einer Arbeitsschrittanweisung A zum Sichern und Abschranken der benachbarten spannungsführenden elektronischen Komponenten K2, K3 durch das Arbeitsschrittablaufprogramm, vorliegend unter Verwendung der Barriereeinrichtung AS.

Nach dem Sichern und Abschranken erfolgt in Schritt S13 ein manuelles Bestätigen des Sicherns und Abschrankens benachbarter spannungsführender elektronischer Komponenten K2, K3 am mobilen Kommunikationsgerät 1 über eine Eingabe des Benutzers am Bestätigungsfeld Q.

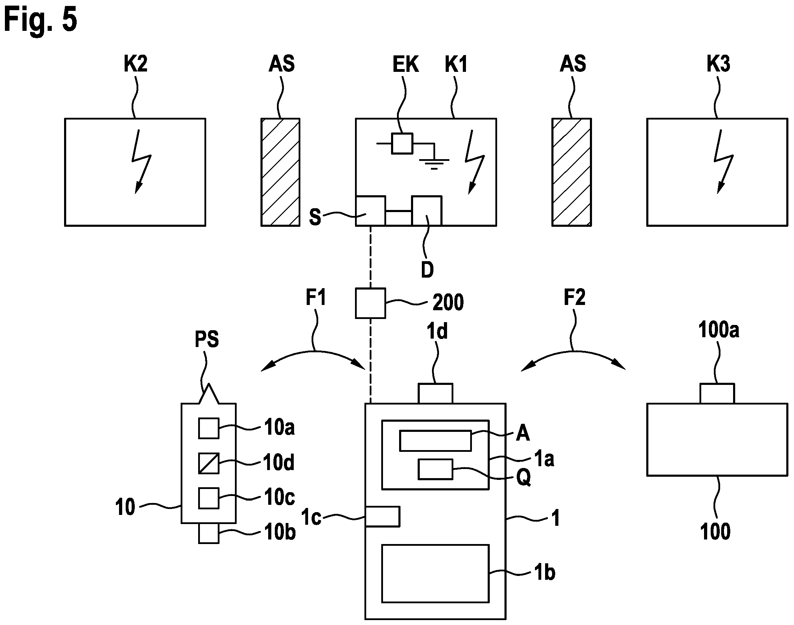

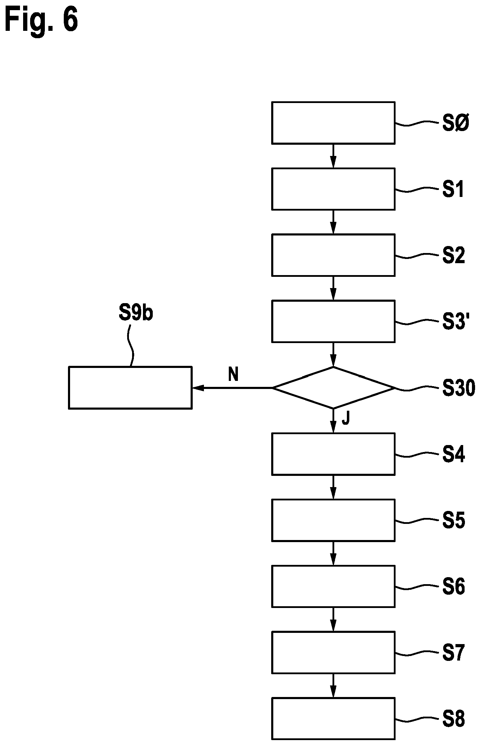

Fig. 5 zeigt eine Vorrichtung zum automatischen Überwachen eines elektrotechnischen Arbeitsablaufs gemäß einer dritten Ausführungsform der vorliegenden Erfindung, und Fig. 6 zeigt ein Ablaufdiagramm eines Verfahrens zum automatischen Überwachen eines elektrotechnischen Arbeitsablaufs gemäß der dritten Ausführungsform der vorliegenden Erfindung.

Die Vorrichtung zum automatischen Überwachen eines elektrotechnischen Arbeitsablaufs gemäß Fig. 5 unterscheidet sich von der Vorrichtung gemäß Fig. 1 dadurch, dass das Bestätigen S3' des Freischaltens der elektronischen Komponente K1 automatisch durch eine mit dem mobilen Kommunikationsgerät 1 kommunikationsmäßig verbundene Freischalt-Bestätigungseinrichtung 200 erfolgt und nicht manuell durch den Benutzer. Das automatische Bestätigen S3' kann über eine Eingabe des Benutzers am Bestätigungsfeld Q ausgelöst werden nach Ausgeben der Arbeitsschrittanweisung A zum Freischalten einer spannungsführenden elektronischen Komponente K1 in Schritt S2.

Die Freischalt-Bestätigungseinrichtung 200 ist beispielsweise ebenfalls mit einer drahtlosen Übertragungsfunktion ausgestattet und/oder verdrahtet bzw. teilverdrahtet an den Spannungsschalter S und das mobile Kommunikationsgerät 1 angeschlossen.

Gemäß Fig. 6 wird in Schritt S30 das Betätigen vom Arbeitsschrittablaufprogramm überprüft. Bei erfolgreichem Bestätigen (J in Schritt S30) schreitet das Arbeitsschrittablaufprogramm voran zu Schritt S4 und folgende, wie oben bereits beschrieben.

Bei fehlgeschlagenem Bestätigen (N in Schritt S30) erfolgt in Schritt S9b ein Ausgeben eines zweiten Alarmsignals durch das mobile Kommunikationsgerät 1, und die Ausgabe weiterer Arbeitsschrittanweisungen A wird gestoppt.

Die Freischalt-Bestätigungseinrichtung 200 weist beispielsweise eine Bilderkennungseinrichtung und/oder eine Schaltzustandsmeldeeinrichtung des zum Freischalten zu betätigenden Spannungsschalters S und/oder eine Elektrolumineszenz-Messeinrichtung zum Messen eines elektrisch Feldes an der elektronischen Komponente K1 auf.

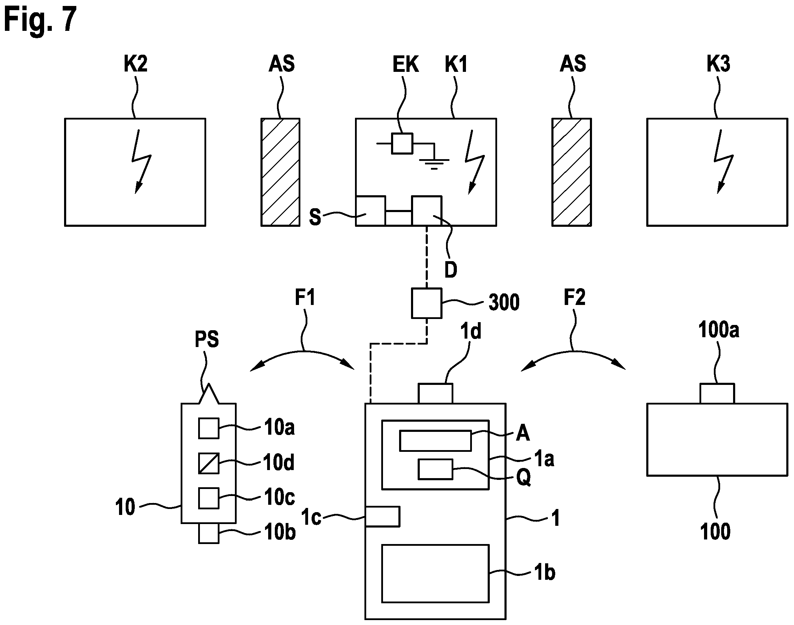

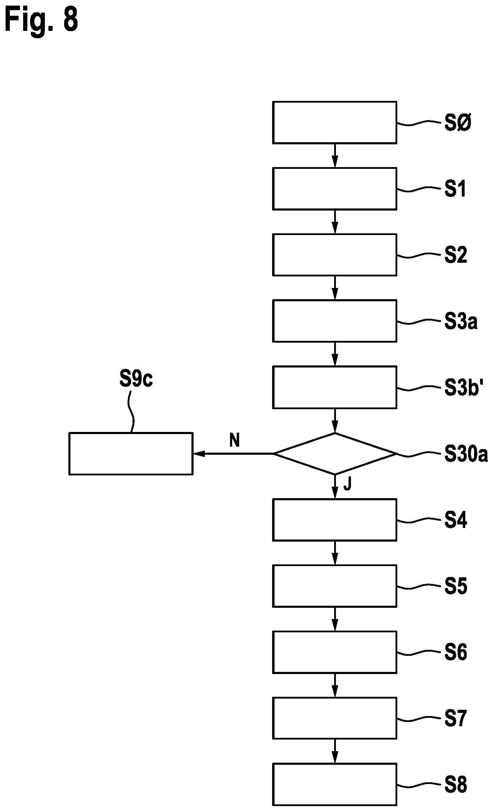

Fig. 7 zeigt eine Vorrichtung zum automatischen Überwachen eines elektrotechnischen Arbeitsablaufs gemäß einer vierten Ausführungsform der vorliegenden Erfindung, und Fig. 8 zeigt ein Ablaufdiagramm eines Verfahrens zum automatischen Überwachen eines elektrotechnischen Arbeitsablaufs gemäß der vierten Ausführungsform der vorliegenden Erfindung.

Die Vorrichtung zum automatischen Überwachen eines elektrotechnischen Arbeitsablaufs gemäß Fig. 7 unterscheidet sich von der Vorrichtung gemäß Fig. 3 dadurch, dass das Bestätigen S3b' des Sicherns der elektronischen Komponente K1 gegen ein Wiedereinschalten automatisch durch eine mit dem mobilen Kommunikationsgerät 1 kommunikationsmäßig verbundene Wiedereinschaltsicherungs-Bestätigungseinrichtung 300 erfolgt und nicht manuell durch den Benutzer. Das automatische Bestätigen S3b' kann über eine Eingabe des Benutzers am Bestätigungsfeld Q ausgelöst werden nach Ausgeben der Arbeitsschrittanweisung A zum Sichern der elektronischen Komponente K1 gegen ein Wiedereinschalten.

Die Wiedereinschaltsicherungs-Bestätigungseinrichtung 300 ist beispielsweise ebenfalls mit einer drahtlosen Übertragungsfunktion ausgestattet und/oder verdrahtet bzw. teilverdrahtet an das Schloss D und das mobile Kommunikationsgerät 1 angeschlossen.

Gemäß Fig. 8 wird in Schritt S30a das Bestätigen vom Arbeitsschrittablaufprogramm überprüft. Bei erfolgreichem Bestätigen (J in Schritt S30a) schreitet das Arbeitsschrittablaufprogramm voran zu Schritt S4 und folgende, wie oben bereits beschrieben.

Bei fehlgeschlagenem Bestätigen (N in Schritt S30a) erfolgt in Schritt S9c ein Ausgeben eines dritten Alarmsignals durch das mobile Kommunikationsgerät 1, und die Ausgabe weiterer Arbeitsschrittanweisungen A wird gestoppt.

Die die Wiedereinschaltsicherungs-Bestätigungseinrichtung 300 weist beispielsweise eine Bilderkennungseinrichtung und/oder eine Sperrzustandsmeldeeinrichtung des zum Wiedereinschaltsichern zu betätigenden Schlosses D auf.

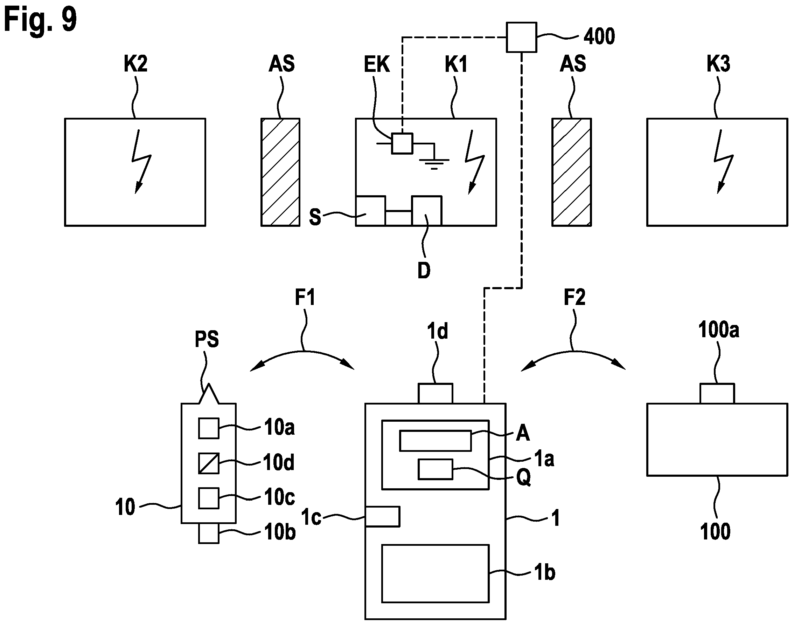

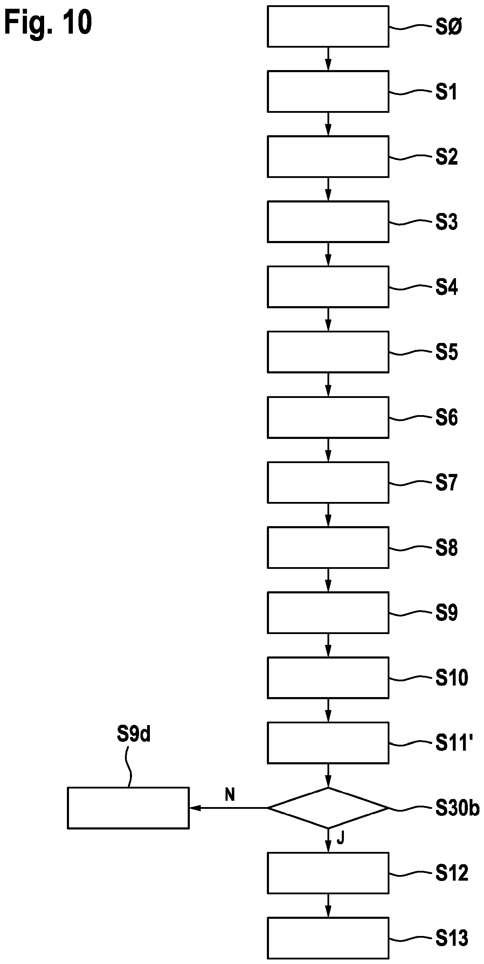

Fig. 9 zeigt eine Vorrichtung zum automatischen Überwachen eines elektrotechnischen Arbeitsablaufs gemäß einer fünften Ausführungsform der vorliegenden Erfindung und Fig. 10 zeigt ein Ablaufdiagramm eines Verfahrens zum automatischen Überwachen eines elektrotechnischen Arbeitsablaufs gemäß der fünften Ausführungsform der vorliegenden Erfindung.

Die Vorrichtung zum automatischen Überwachen eines elektrotechnischen Arbeitsablaufs gemäß Fig. 9 unterscheidet sich von der Vorrichtung gemäß Fig. 3 dadurch, dass das Bestätigen S11 ` des Erdens und Kurzschliessens der elektronischen Komponente K1 automatisch durch eine mit dem mobilen Kommunikationsgerät 1 kommunikationsmäßig verbundene Erdungs-/Kurzschluss-Bestätigungseinrichtung 400 erfolgt und nicht manuell durch den Benutzer. Das automatische Bestätigen S11 ` kann über eine Eingabe des Benutzers am Bestätigungsfeld Q ausgelöst werden nach Ausgeben der Arbeitsschrittanweisung A zum Erden und Kurzschliessen der elektronischen Komponente K1.

Die Erdungs-/Kurzschluss-Bestätigungseinrichtung 400 ist beispielsweise ebenfalls mit einer drahtlosen Übertragungsfunktion ausgestattet und/oder verdrahtet bzw. teilverdrahtet an die Klemmeinrichtung EK und das mobile Kommunikationsgerät 1 angeschlossen.

Gemäß Fig. 10 wird in Schritt S30b das Bestätigen vom Arbeitsschrittablaufprogramm überprüft. Bei erfolgreichem Bestätigen (J in Schritt S30b) schreitet das Arbeitsschrittablaufprogramm voran zu Schritt S12 und folgende, wie oben bereits beschrieben.

Bei fehlgeschlagenem Bestätigen (N in Schritt S30b) erfolgt in Schritt 9d ein Ausgeben eines vierten Alarmsignals durch das mobile Kommunikationsgerät 1, und die Ausgabe weiterer Arbeitsschrittanweisungen A wird gestoppt.

Die Erdungs-/Kurzschluss-Bestätigungseinrichtung 400 weist beispielweise eine Bilderkennungseinrichtung und/oder eine Klemmerfassungseinrichtung (z.B. Druckschalter, Endschalter o.ä.) zum Erfassen einer Klemmung der zum Erden und Kurzschliessen verwendeten Klemmeinrichtung EK und/oder eine Einrichtung zum Erfassen von Kugelfestpunkten einer Kugelkopfhaube der Klemmeinrichtung EK auf.

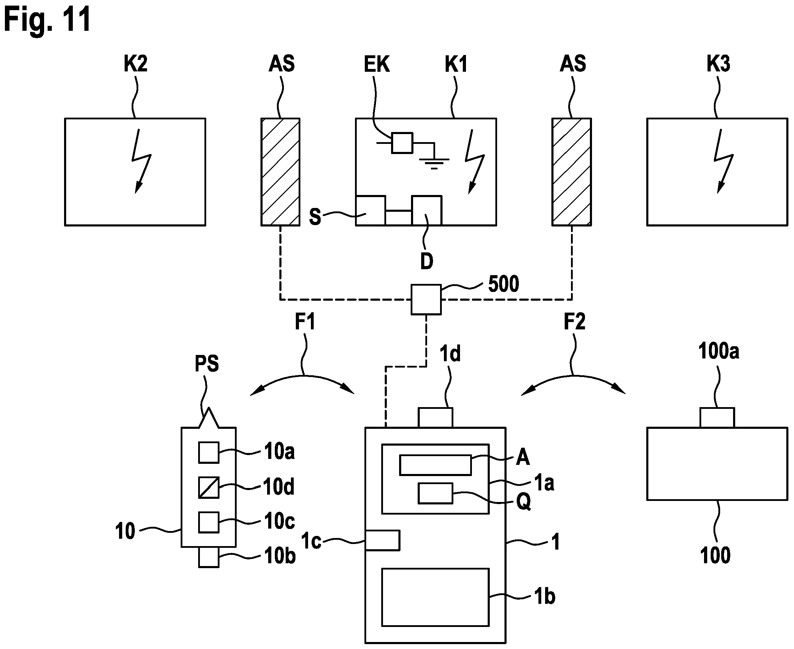

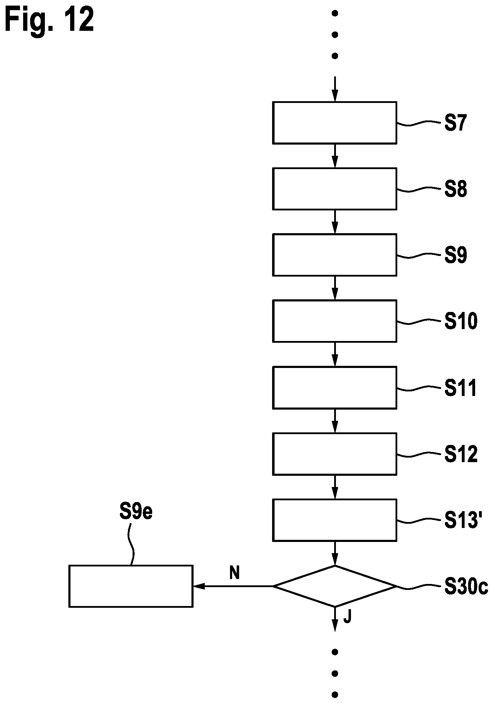

Fig. 11 zeigt eine Vorrichtung zum automatischen Überwachen eines elektrotechnischen Arbeitsablaufs gemäß einer sechsten Ausführungsform der vorliegenden Erfindung, und Fig. 12 zeigt ein Ablaufdiagramm eines Verfahrens zum automatischen Überwachen eines elektrotechnischen Arbeitsablaufs gemäß der sechsten Ausführungsform der vorliegenden Erfindung.

Die Vorrichtung zum automatischen Überwachen eines elektrotechnischen Arbeitsablaufs gemäß Fig. 11 unterscheidet sich von der Vorrichtung gemäß Fig. 3 dadurch, dass das Bestätigen S13` des Sicherns und Abschrankens der benachbarten spannungsführenden elektronischen Komponenten K2, K3 automatisch durch eine mit dem mobilen Kommunikationsgerät 1 kommunikationsmäßig verbundene Sicherungs/Abschrankungs-Bestätigungseinrichtung 500 erfolgt und nicht manuell durch den Benutzer. Das automatische Bestätigen S13` kann über eine Eingabe des Benutzers am Bestätigungsfeld Q ausgelöst werden nach Ausgeben der Arbeitsschrittanweisung A zum Sichern und Abschranken der elektronischen Komponente K1.

Die Sicherungs/Abschrankungs-Bestätigungseinrichtung 500 ist beispielsweise ebenfalls mit einer drahtlosen Übertragungsfunktion ausgestattet und/oder verdrahtet bzw. teilverdrahtet an die Barriereeinrichtung AS und das mobile Kommunikationsgerät 1 angeschlossen.

Gemäß Fig. 12 wird in Schritt S30c das Bestätigen vom Arbeitsschrittablaufprogramm überprüft. Bei erfolgreichem Bestätigen (J in Schritt S30c) schreitet das Arbeitsschrittablaufprogramm voran zu etwaigen weiteren Arbeitsschrittanweisungen oder wird beendet.

Bei fehlgeschlagenem Bestätigen (N in Schritt 30c) erfolgt in Schritt S9e ein Ausgeben eines fünften Alarmsignals durch das mobile Kommunikationsgerät 1, und die Ausgabe weiterer Arbeitsschrittanweisungen A wird gestoppt.

Die Sicherungs/Abschrankungs-Bestätigungseinrichtung 500 weist beispielsweise eine Bilderkennungseinrichtung und/oder eine Lageerfassungseinrichtung einer Lage der zum Sichern und Abschranken verwendeten Barriereeinrichtung AS auf.

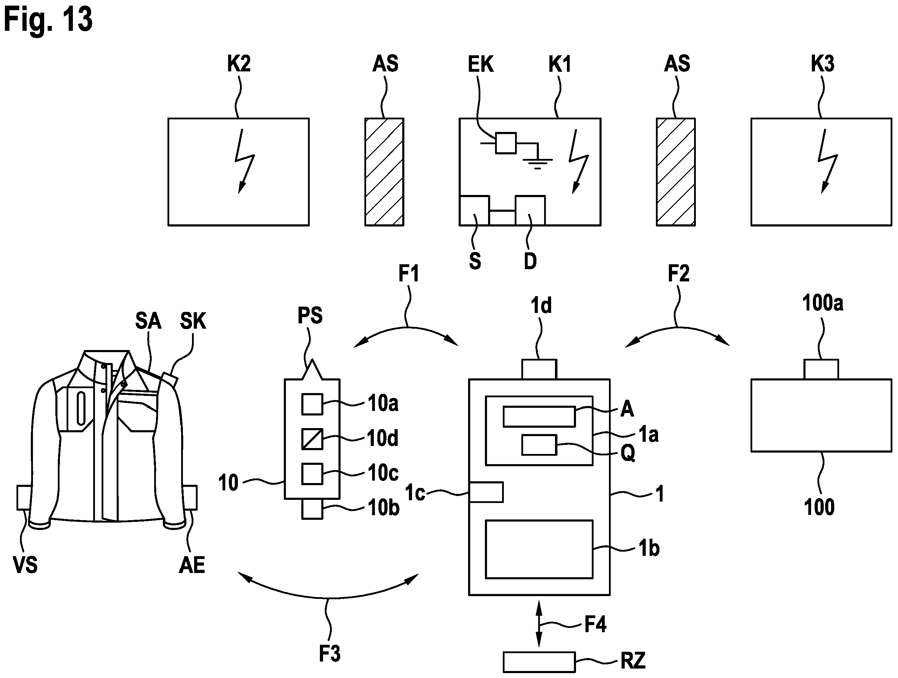

Fig. 13 zeigt eine Vorrichtung zum automatischen Überwachen eines elektrotechnischen Arbeitsablaufs gemäß einer siebenten Ausführungsform der vorliegenden Erfindung.

Die Vorrichtung zum automatischen Überwachen eines elektrotechnischen Arbeitsablaufs gemäß Fig. 13 unterscheidet sich von der Vorrichtung gemäß Fig. 3 dadurch, dass ein Schutzausrüstungsgegenstand SA für einen Benutzer vorgesehen ist, der eine dritte bidirektionale Kommunikationsschnittstelle VS aufweist.

Eine dritte bidirektionale Kommunikationsverbindung F3 ist zwischen dem mobilen Kommunikationsgerät 1 und dem Schutzausrüstungsgegenstand SA über die erste bidirektionale Kommunkationsschnittstelle 1d und die dritte bidirektionale Kommunikationsschnittstelle VS im Arbeitsschrittablaufprogramm einrichtbar.

Das mobile Kommunikationsgerät 1 überträgt zumindest eines des ersten bis fünften Alarmsignals über die dritte bidirektionale Kommunikationsverbindung F3 an den Schutzausrüstungsgegenstand SA zum Auslösen einer am Schutzausrüstungsgegenstand SA angebrachten optischen und/oder akustischen Warneinrichtung AE und/oder einer Vibrationsalarmeinrichtung. Der Schutzausrüstungsgegenstand SA ist z.B. eine Schutzjacke, ein Schutzhelm, eine Schutzbrille, ein Schutzmantel, ein Schutzoverall, ein Schaltmantel o.ä..

Der Schutzausrüstungsgegenstand SA weist weiterhin einen Vitalsensor VS auf, und die Vitaldaten des Benutzers sind über die dritte bidirektionale Kommunikationsverbindung F3 an das mobile Kommunikationsgerät 1 übermittelbar. Das mobile Kommunikationsgerät 1 ist eingerichtet, bei übermittelten kritischen Vitaldaten des Benutzers eine vierte bidirektionale Kommunikationsverbindung F4 mit einer Rettungszentrale RZ aufzubauen, z.B. über die GSM-Funktion.

Der Schutzausrüstungsgegenstand SA kann z.B. auch weitere (nicht dargestellte) Sensoren zur Erhöhung der Sicherheit aufweisen, z.B. einen Feuchtesensor, einen Bewegungssensor, einen Beschleunigungssensor usw., welche eine Arbeitsschrittanweisung über eine drahtlose Kommunkationsverbindung sperren oder abbrechen können.

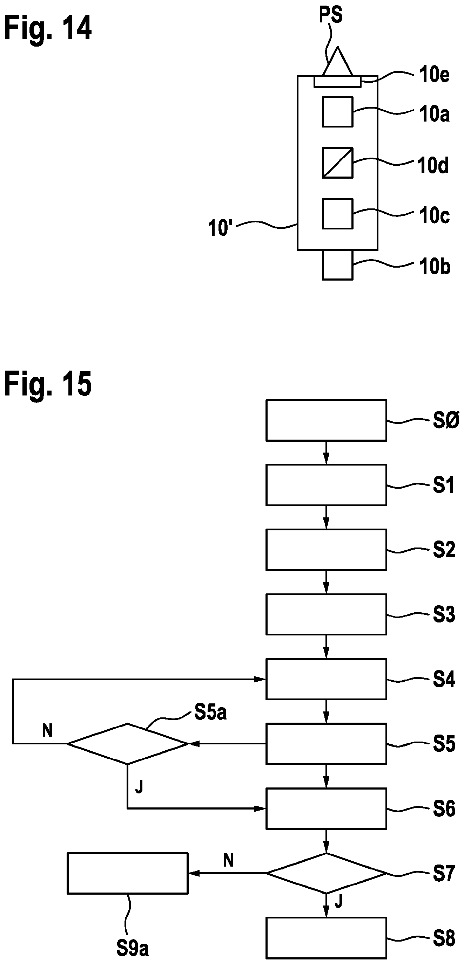

Fig. 14 zeigt eine Spannungsprüfeinrichtung für eine Vorrichtung zum automatischen Überwachen eines elektrotechnischen Arbeitsablaufs gemäß einer achten Ausführungsform der vorliegenden Erfindung, und Fig. 15 zeigt ein Ablaufdiagramm eines Verfahrens zum automatischen Überwachen eines elektrotechnischen Arbeitsablaufs gemäß der achten Ausführungsform der vorliegenden Erfindung.

Die mobile Spannungsprüfeinrichtung 10' gemäß Fig. 14 ist mit dem mobilen Kommunikationsgerät 1 kommunikationsmäßig verbunden. Es weist eine Spannungsprüfpunkt-Bestätigungseinrichtung 10e zum Bestätigen des korrekten Spannungsprüfpunktes vor, beispielsweise eine Bilderkennungseinrichtung und/oder eine in der mobilen Spannungsprüfeinrichtung integrierte Sensoreinrichtung.

Gemäß Fig. 15 erfolgt nach den Schritten S0 bis S5, welche zuvor beschrieben wurden, also vor dem Kommunizeren des Prüfergebnisses in Schritt S6 zusätzlich in Schritt S5a ein Prüfen des Spannungsprüfpunktes durch die Spannungsprüfpunkt-Bestätigungseinrichtung 10e, um sicherzustellen, dass die Spannung am vorgesehenen Spannungsprüfpunkt gemessen wurde oder die Spannungsprüfeinrichtung 10' ordnungsgemäß betrieben wurde.

Bei erfolgreicher Prüfung (J in Schritt S5a) erfolgt in Schritt S6 das Kommunizeren des Prüfergebnisses von der mobilen Spannungsprüfeinrichtung 10' an das mobile Kommunikationsgerät 1. Anderenfalls springt das Arbeitsschrittablaufprogramm zurück zu Schritt S4.

Obwohl die vorliegende Erfindung anhand bevorzugter Ausführungsformen beschrieben wurde, ist sie nicht darauf beschränkt, sondern generell auf beliebige elektrotechnische Arbeitsabläufe anwendbar, bei denen eine mobile Spannungsprüfeinrichtung verwendet wird.

## Patentansprüche

1. Verfahren zum automatischen Überwachen eines elektrotechnischen Arbeitsablaufs mit einer Mehrzahl von Arbeitsschritten, welches folgende Schritte aufweist:
Errichten (S0) einer ersten bidirektionalen Kommunikationsverbindung (F1) zwischen einem mobilen Kommunikationsgerät (1) und einer mobilen Spannungsprüfeinrichtung (10; 10');
Starten (S1) eines Arbeitsschrittablaufprogramms auf einem mobilen Kommunikationsgerät (1) mittels einer Eingabeeinrichtung (1b) des mobilen Kommunikationsgeräts (1),
Ausgeben (S2) einer Arbeitsschrittanweisung (A) zum Freischalten einer spannungsführenden elektronischen Komponente (K1) zum Bewirken einer Spannungsfreiheit der elektronischen Komponente (K1) auf einer Ausgabeeinrichtung (1a) des mobilen Kommunikationsgeräts (1) durch das Arbeitsschrittablaufprogramm;
automatisches oder manuelles Bestätigen (S3; S3') des Freischaltens der elektronischen Komponente (K1) am mobilen Kommunikationsgerät (1),
nach dem Bestätigen (S3; S3') des Freischaltens der elektronischen Komponente (K1) Ausgeben (S4) einer Arbeitsschrittanweisung (A) zum Überprüfen der Spannungsfreiheit der elektronischen Komponente (K1) mittels der mobilen Spannungsprüfeinrichtung (10; 10') auf der Ausgabeeinrichtung (1a) des mobilen Kommunikationsgeräts (1) durch das Arbeitsschrittablaufprogramm;
Überprüfen (S5) der Spannungsfreiheit der elektronischen Komponente (K1) mittels der mobilen Spannungsprüfeinrichtung (10; 10');
Kommunizieren (S6) des Prüfergebnisses von der mobilen Spannungsprüfeinrichtung (10; 10') an das mobile Kommunikationsgerät (1),
falls das Prüfergebnis eine Spannungsfreiheit anzeigt, automatisches Bestätigen (S8) des Überprüfens der Spannungsfreiheit der elektronischen Komponente (K1) durch Ausgeben eines Bestätigungssignals durch das mobile Kommunikationsgerät (1),
falls das Prüfergebnis keine Spannungsfreiheit anzeigt, Ausgeben (S9a) eines ersten Alarmsignals durch das mobile Kommunikationsgerät (1).

2. Verfahren nach Anspruch 1, wobei eine zweite bidirektionale Kommunikationsverbindung (F2) zwischen dem mobilen Kommunikationsgerät (1) und einem zentralen stationären Kommunikationsgerät (100) eingerichtet wird und wobei das Prüfergebnis von der mobilen Spannungsprüfeinrichtung (10; 10') an das zentrale stationäre Kommunikationsgerät (100) kommuniziert wird.

3. Verfahren nach Anspruch 1 oder 2, wobei mindestens ein in der mobilen Spannungsprüfeinrichtung (10; 10') speicherbarer Prüfparameter durch das mobile Kommunikationsgerät (1) abfragbar und/oder einstellbar ist.

4. Verfahren nach Anspruch 3, wobei der Prüfparameter eine akustische oder elektronische Anzeigeeinstellung und/oder eine Zusatzfunktion und/oder einen Nenndatenparameter, insbesondere einen Spannungsmessbereich, und/oder eine Batteriekapazität und/oder einen Prüfpflichtzeitpunkt der Wiederholungsprüfung und/oder eine Betriebsbereitschaft der mobilen Spannungsprüfeinrichtung (10; 10') umfasst.

5. Verfahren nach einem der vorhergehenden Ansprüche, wobei das mobile Kommunikationsgerät (1) eine Zeiterfassungseinrichtung aufweist und das Überprüfen (S5) der Spannungsfreiheit der elektronischen Komponente (K1) durch die mobile Spannungsprüfeinrichtung (10; 10') zeitmäßig durch das Arbeitsschrittablaufprogramm erfasst und im mobilen Kommunikationsgerät (1) gespeichert wird.

6. Verfahren nach einem der vorhergehenden Ansprüche, wobei das mobile Kommunikationsgerät (1) eine GPS-Ortungseinrichtung aufweist und das Überprüfen (S5) der Spannungsfreiheit der elektronischen Komponente (K1) durch die Spannungsprüfeinrichtung (10; 10') ortsmäßig durch das Arbeitsschrittablaufprogramm erfasst und im mobilen Kommunikationsgerät (1) gespeichert wird.

7. Verfahren nach einem der vorhergehenden Ansprüche, wobei das mobile Kommunikationsgerät (1) eine Wetterprognoseeinrichtung aufweist und bei Vorliegen einer vorbestimmten Wetterprognose, insbesondere eine Gewitterprognose, einen Warnhinweis im Arbeitsschrittablaufprogramm ausgibt.

8. Verfahren nach einem der vorhergehenden Ansprüche, wobei das Bestätigen (S3') des Freischaltens der elektronischen Komponente (K1) automatisch durch eine mit dem mobilen Kommunikationsgerät (1) kommunikationsmäßig verbundene Freischalt-Bestätigungseinrichtung (200) erfolgt und bei fehlgeschlagenem Bestätigen (S3') ein Ausgeben (S9b) eines zweiten Alarmsignals durch das mobile Kommunikationsgerät (1) erfolgt und wobei die Freischalt-Bestätigungseinrichtung (200) eine Bilderkennungseinrichtung und/oder eine Schaltzustandsmeldeeinrichtung eines zum Freischalten zu betätigenden Hardware- und/ oder Software-Spannungsschalters (S) und/oder eine Elektrolumineszenz-Messeinrichtung zum Messen eines elektrischen Feldes an der elektronischen Komponente (K1) aufweist.

9. Verfahren nach einem der vorhergehenden Ansprüche, wobei nach dem Bestätigen (S3; S3') des Freischaltens der elektronischen Komponente (K1) und vor dem Ausgeben (S4) der Arbeitsschrittanweisung (A) zum Überprüfen der Spannungsfreiheit der elektronischen Komponente (K1) ein Ausgeben (S3a) einer Arbeitsschrittanweisung (A) zum Sichern der elektronischen Komponente (K1) gegen ein Wiedereinschalten durch das Arbeitsschrittablaufprogramm und anschließend ein automatisches oder manuelles Bestätigen (S3b; S3b') des Sicherns der elektronischen Komponente (K1) gegen ein Wiedereinschalten am mobilen Kommunikationsgerät (1) erfolgt.

10. Verfahren nach Anspruch 9, wobei das Bestätigen (S3b') des Sicherns der elektronischen Komponente (K1) gegen ein Wiedereinschalten automatisch durch eine mit dem mobilen Kommunikationsgerät (1) kommunikationsmäßig verbundene Wiedereinschaltsicherungs-Bestätigungseinrichtung (300) erfolgt und bei fehlgeschlagenem Bestätigen (S3b') ein Ausgeben (S9c) eines dritten Alarmsignals durch das mobile Kommunikationsgerät (1) erfolgt und wobei die Wiedereinschaltsicherungs-Bestätigungseinrichtung (300) eine Bilderkennungseinrichtung und/oder eine Sperrzustandsmeldeeinrichtung eines zum Wiedereinschaltsichern zu betätigenden Schlosses (D) aufweist.

11. Verfahren nach einem der vorhergehenden Ansprüche, wobei, falls das Prüfergebnis eine Spannungsfreiheit anzeigt und das Bestätigungssignal von dem mobilen Kommunikationsgerät (1) ausgegeben wird, ein Ausgeben (S10) einer Arbeitsschrittanweisung (A) zum Erden und Kurzschliessen der elektronischen Komponente (K1) durch das Arbeitsschrittablaufprogramm und anschließend ein automatisches oder manuelles Bestätigen (S11; S11') des Erdens und Kurzschliessens der elektronischen Komponente (K1) am mobilen Kommunikationsgerät (1) erfolgt.

12. Verfahren nach Anspruch 10, wobei das Bestätigen (S11`) des Erdens und Kurzschliessens der elektronischen Komponente (K1) automatisch durch eine mit dem mobilen Kommunikationsgerät (1) kommunikationsmäßig verbundene Erdungs-/ Kurzschluss-Bestätigungseinrichtung (400) erfolgt und bei fehlgeschlagenem Bestätigen (S11') ein Ausgeben (S9d) eines vierten Alarmsignals durch das mobile Kommunikationsgerät (1) erfolgt und wobei die Erdungs-/Kurzschluss-Bestätigungseinrichtung (400) eine Bilderkennungseinrichtung und/oder eine Klemmerfassungseinrichtung zum Erfassen einer Klemmung einer zum Erden und Kurzschliessen verwendeten Klemmeinrichtung (EK) und/oder eine Einrichtung zum Erfassen von Kugelfestpunkten einer Kugelkopfhaube der Klemmeinrichtung (EK) aufweist.

13. Verfahren nach Anspruch 11 oder 12, wobei nach dem Bestätigen (S11) des Erdens und Kurzschliessens der elektronischen Komponente (K1) ein Ausgeben (S12) einer Arbeitsschrittanweisung (A) zum Sichern und Abschranken benachbarter spannungsführender elektronischer Komponenten (K2, K3) durch das Arbeitsschrittablaufprogramm ausgegeben und anschließend ein automatisches oder manuelles Bestätigen (S13; S13`) des Sicherns und Abschrankens benachbarter spannungsführender elektronischer Komponenten (K2, K3) am mobilen Kommunikationsgerät (1) erfolgt.

14. Verfahren nach Anspruch 13, wobei das Bestätigen (S13') des Sicherns und Abschrankens benachbarter spannungsführender elektronischer Komponenten (K2, K3) automatisch durch eine mit dem mobilen Kommunikationsgerät (1) kommunikationsmäßig verbundene Sicherungs/Abschrankungs-Bestätigungseinrichtung (500) erfolgt und bei fehlgeschlagenem Bestätigen (S13') ein Ausgeben (S9e) eines fünften Alarmsignals durch das mobile Kommunikationsgerät (1) erfolgt und wobei die Sicherungs/Abschrankungs-Bestätigungseinrichtung (500) eine Bilderkennungseinrichtung und/oder eine Lageerfassungseinrichtung (LE) einer Lage einer zum Sichern und Abschranken verwendeten Barriereeinrichtung (AS) aufweist.

15. Verfahren nach einem der vorhergehenden Ansprüche, wobei ein Schutzausrüstungsgegenstand (SA) für einen Benutzer vorgesehen wird, wobei eine dritte bidirektionale Kommunikationsverbindung (F3) zwischen dem mobilen Kommunikationsgerät (1) und dem Schutzausrüstungsgegenstand (SA) eingerichtet wird und wobei das das mobile Kommunikationsgerät (1) zumindest eines des ersten bis fünften Alarmsignals über die dritte bidirektionale Kommunikationsverbindung (F3) an den Schutzausrüstungsgegenstand (SA) zum Auslösen einer am Schutzausrüstungsgegenstand (SA) angebrachten optischen und/oder akustischen Warneinrichtung (AE) und/oder Vibrationsalarmeinrichtung überträgt.

16. Verfahren nach Anspruch 15, wobei der Schutzausrüstungsgegenstand (SA) Schutzjacke und/oder einen Schutzhelm und/oder eine Schutzbrille und/oder einen Schutzmantel und/oder ein Schutzoverall und/oder einen Schaltmantel aufweist.

17. Verfahren nach Anspruch 15 oder 16, wobei der Schutzausrüstungsgegenstand (SA) einen Vitalsensor (VS) aufweist und die Vitaldaten des Benutzers über die dritte bidirektionale Kommunikationsverbindung (F3) an das mobile Kommunikationsgerät (1) übermittelt werden.

18. Verfahren nach Anspruch 15, wobei das mobile Kommunikationsgerät (1) eingerichtet ist, bei übermittelten kritischen Vitaldaten des Benutzers eine vierte uni- oder bidirektionale Kommunikationsverbindung (F4) mit einer Rettungszentrale (RZ) aufzubauen.

19. Verfahren nach einem der vorhergehenden Ansprüche, wobei zumindest ein Teil der Arbeitsanweisungen, das zugehörige jeweilige Bestätigen bzw. fehlgeschlagene Bestätigen und das jeweilige Alarmsignal bei fehlgeschlagenem Bestätigen im mobilen Kommunikationsgerät (1) protokolliert und gespeichert wird.

20. Verfahren nach einem der vorhergehenden Ansprüche, wobei das mobile Kommunikationsgerät (1) ein Smartphone oder ein Laptop oder Tablet oder eine Smartbrille oder eine Smartwatch umfasst.

21. Verfahren nach einem der vorhergehenden Ansprüche, wobei eine mit dem mobilen Kommunikationsgerät (1) kommunikationsmäßig verbundene Spannungsprüfpunkt-Bestätigungseinrichtung (10e) zum Bestätigen des Spannungsprüfpunktes vorgesehen ist, wobei vor dem Kommunizeren (S6) des Prüfergebnisses ein Prüfen (S5a) des Spannungsprüfpunktes durch die Spannungsprüfpunkt-Bestätigungseinrichtung (10e) erfolgt und wobei nur bei erfolgreicher Prüfung das Kommunizeren (S6) des Prüfergebnisses von der mobilen Spannungsprüfeinrichtung (10; 10') an das mobile Kommunikationsgerät (1) erfolgt.

22. Verfahren nach Anspruch 21, wobei die Spannungsprüfpunkt-Bestätigungseinrichtung (10e) eine Bilderkennungseinrichtung und/oder eine in der mobilen Spannungsprüfeinrichtung (10; 10') integrierte Sensoreinrichtung aufweist.

23. Vorrichtung zum automatischen Überwachen eines elektrotechnischen Arbeitsablaufs, eingerichtet zur Durchführung des Verfahrens nach einem der vorhergehenden Ansprüche, mit:
einem mobilen Kommunikationsgerät (1), welches eine erste Eingabeeinrichtung (1b), eine erste Ausgabeeinrichtung (1a), eine erste Speichereinrichtung (1c) und eine erste bidirektionale Kommunikationsschnittstelle (1d) aufweist;
einem auf dem mobilen Kommunikationsgerät (1) gespeicherten Arbeitsschrittablaufprogramm;
einer mobilen Spannungsprüfeinrichtung (10; 10'), welche eine zweite Eingabeeinrichtung (10c), eine zweite Ausgabeeinrichtung (10a), eine zweite Speichereinrichtung (10d) und eine zweite bidirektionale Kommunikationsschnittstelle (10b) aufweist;
wobei eine erste bidirektionale Kommunikationsverbindung (F1) zwischen dem mobilen Kommunikationsgerät (1) und der mobilen Spannungsprüfeinrichtung (10; 10') über die erste und zweite bidirektionale Kommunikationsschnittstelle (1d, 10b) einrichtbar ist.

24. Vorrichtung nach Anspruch 23, insbesondere zur Durchführung des Verfahrens nach Anspruch 8, weiterhin aufweisend eine mit dem mobilen Kommunikationsgerät (1) kommunikationsmäßig verbindbare Freischalt-Bestätigungseinrichtung (200), welche eine Bilderkennungseinrichtung und/oder eine Schaltzustandsmeldeeinrichtung (SM) eines zum Freischalten zu betätigenden Spannungsschalters (S) und/oder eine Elektrolumineszenz-Messeinrichtung zum Messen eines elektrisch Feldes an der elektronischen Komponente (K1) aufweist.

25. Vorrichtung nach Anspruch 23 oder 24, insbesondere zur Durchführung des Verfahrens nach Anspruch 10, weiterhin aufweisend eine mit dem mobilen Kommunikationsgerät (1) verbindbare Wiedereinschaltsicherungs-Bestätigungseinrichtung (300), welche eine Bilderkennungseinrichtung und/oder eine Sperrzustandsmeldeeinrichtung eines zum Wiedereinschaltsichern zu betätigenden Schlosses (D) aufweist.

26. Vorrichtung nach Anspruch 23, 24 oder 25, insbesondere zur Durchführung des Verfahrens nach Anspruch 12, weiterhin aufweisend eine mit dem mobilen Kommunikationsgerät (1) verbindbare Erdungs-/Kurzschluss-Bestätigungseinrichtung (400), welche eine Bilderkennungseinrichtung und/oder eine Klemmerfassungseinrichtung zum Erfassen einer Klemmung einer zum Erden und Kurzschliessen verwendeten Klemmeinrichtung (EK) und/oder eine Einrichtung zum Erfassen von Kugelfestpunkten einer Kugelkopfhaube der Klemmeinrichtung (EK) aufweist.

27. Vorrichtung nach einem der Ansprüche 23 bis 26, insbesondere zur Durchführung des Verfahrens nach Anspruch 14, weiterhin aufweisend eine mit dem mobilen Kommunikationsgerät (1) verbindbare Sicherungs/Abschrankungs-Bestätigungseinrichtung (500), welche eine Bilderkennungseinrichtung und/oder eine Lageerfassungseinrichtung (LE) einer Lage einer zum Sichern und Abschranken verwendeten Barriereeinrichtung (AS) aufweist.

28. Vorrichtung nach einem der Ansprüche 23 bis 27 zur Durchführung des Verfahrens nach Anspruch 15, weiterhin aufweisend einen Schutzausrüstungsgegenstand (SA) für einen Benutzer mit einer dritten bidirektionalen Kommunikationsschnittstelle (SK) und eine am Schutzausrüstungsgegenstand (SA) angebrachte optische und/oder akustische Warneinrichtung (AE) und/oder Vibrationsalarmeinrichtung, wobei eine dritte bidirektionale Kommunikationsverbindung (F3) zwischen dem mobilen Kommunikationsgerät (1) und dem Schutzausrüstungsgegenstand (SA) über die erste und dritte bidirektionale Kommunikationsschnittstelle (SK) einrichtbar ist.

29. Vorrichtung nach Anspruch 28, wobei der Schutzausrüstungsgegenstand (SA) Schutzjacke und/oder einen Schutzhelm und/oder eine Schutzbrille und/oder einen Schutzmantel und/oder ein Schutzoverall und/oder einen Schaltmantel aufweist.

30. Vorrichtung nach Anspruch 28 oder 29, wobei der Schutzausrüstungsgegenstand (SA) einen Vitalsensor (VS) aufweist.

31. Vorrichtung nach einem der Ansprüche 23 bis 30, wobei das mobile Kommunikationsgerät (1) ein Smartphone oder ein Laptop oder Tablet oder eine Smartbrille oder eine Smartwatch umfasst.

32. Vorrichtung nach einem der Ansprüche 23 bis 31, weiterhin umfassend eine mit dem mobilen Kommunikationsgerät (1) verbindbare Spannungsprüfpunkt-Bestätigungseinrichtung (10e) zum Bestätigen des Spannungsprüfpunktes der mobilen Spannungsprüfeinrichtung (10; 10') welche eine Bilderkennungseinrichtung und/oder eine in der mobilen Spannungsprüfeinrichtung (10; 10') integrierte Sensoreinrichtung aufweist.

33. Vorrichtung nach einem der Ansprüche 28 bis 31, wobei der Schutzausrüstungsgegenstand (SA) eine Sensoreinrichtung aufweist, welche ausgestaltet ist, den Zustand, den Gebrauch oder die Wartung des Schutzausrüstungsgegenstandes (SA) zu überwachen und über die dritte bidirektionale Kommunikationsverbindung (SK) an das zentrale stationäre Kommunikationsgerät (100) zu übertragen.

## Claims

1. Method for automatically monitoring an electrical engineering workflow having a plurality of work steps, said method having the following steps:
establishing (S0) a first bidirectional communication connection (F1) between a mobile communication device (1) and a mobile voltage testing means (10; 10');
initiating (S1) a work step sequence program on a mobile communication device (1) using an input means (1b) of the mobile communication device (1),
outputting (S2), by way of the work step sequence program, a work step instruction (A) for enabling a voltage-carrying electronic component (K1) to make the electronic component (K1) voltage-free on an output means (1a) of the mobile communication device (1);
automatically or manually confirming (S3; S3') the enabling of the electronic component (K1) at the mobile communication device (1);
after confirming (S3; S3') the enabling of the electronic component (K1), outputting (S4), by way of the work step sequence program, a work step instruction (A) for checking that the electronic component (K1) is voltage-free using the mobile voltage testing means (10; 10') on the output means (1a) of the mobile communication device (1);
checking (S5) that the electronic component (K1) is voltage-free using the mobile voltage testing means (10; 10');
communicating (S6) the test result from the mobile voltage testing means (10; 10') to the mobile communication device (1) ;
if the test result indicates that there is no voltage, automatically confirming (S8) the check that the electronic component (K1) is voltage-free by outputting a confirmation signal by way of the mobile communication device (1);
if the test result does not indicate that there is no voltage, outputting (S9a) a first alarm signal by way of the mobile communication device (1).

2. Method according to claim 1, wherein a second bidirectional communication connection (F2) is established between the mobile communication device (1) and a central stationary communication device (100) and wherein the test result is communicated from the mobile voltage test means (10; 10') to the central stationary communication device (100).

3. Method according to either claim 1 or claim 2, wherein at least one test parameter storable in the mobile voltage test means (10; 10') can be queried and/or adjusted by the mobile communication device (1).

4. Method according to claim 3, wherein the test parameter comprises an acoustic or electronic display setting and/or an additional function and/or a rated data parameter, in particular a voltage measurement range, and/or a battery capacity and/or a time at which the repeat testing is required and/or an operating readiness of the mobile test means (10; 10').

5. Method according to any of the preceding claims, wherein the mobile communication device (1) has a time detection device, and the check (S5) that the electronic component (K1) is voltage-free by way of the mobile voltage test means (10; 10') is detected in terms of time by the work step sequence program and stored in the mobile communication device (1).

6. Method according to any of the preceding claims, wherein the mobile communication device (1) has a GPS tracking means, and the check (S5) that the electronic component (K1) is voltage-free by way of the mobile voltage test means (10; 10') is detected in terms of location by the work step sequence program and stored in the mobile communication device (1).

7. Method according to any of the preceding claims, wherein the mobile communication device (1) has a weather forecast means and, in the event of a predetermined weather forecast, in particular a storm forecast, outputs a warning message in the work step sequence program.

8. Method according to any of the preceding claims, wherein the enabling of the electronic component (K1) is confirmed (S3') automatically by an enabling confirmation means (200) communicatively connected to the mobile communication device (1), and in the event of failed confirmation (S3') a second alarm signal is outputted (S9b) by the mobile communication device (1), and wherein the enabling confirmation means (200) has an image recognition means and/or a switching state reporting means of a hardware and/or software voltage switch (S) to be actuated for the enabling and/or has an electroluminescence measurement means for measuring an electric field at the electronic component (K1).

9. Method according to any of the preceding claims, wherein, after the enabling of the electronic component (K1) is confirmed (S3; S3') and before the work step instruction (A) to check that the electronic component (K1) is voltage-free is outputted (S4), a work step instruction (A) to secure the electronic component (K1) against restart is outputted (S3a) by the work step sequence program, and subsequently the securing of the electronic component (K1) against restart is automatically or manually confirmed (S3b; S3b') at the mobile communication device (1).

10. Method according to claim 9, wherein the securing of the electronic component (K1) against restart is confirmed (S3b') automatically by way of a restart securing confirmation means (300) communicatively connected to the mobile communication device (1), and in the event of failed confirmation (S3b') a third alarm signal is outputted (S9c) by way of the mobile communication device (1), and wherein the restart securing confirmation means (300) has an image recognition device and/or a blocking state reporting means for a lock (D) to be actuated for securing against restart.

11. Method according to any of the preceding claims, wherein, if the test result indicates that there is no voltage and the confirmation signal is outputted by the mobile communication device (1), a work step instruction (A) for earthing and short-circuiting the electronic component (K1) is outputted (S10) by the work step sequence program, and subsequently the earthing and short-circuiting of the electronic component (K1) is automatically or manually confirmed (S11; S11') at the mobile communication device (1) .

12. Method according to claim 10, wherein the earthing and short-circuiting of the electronic component (K1) is automatically confirmed (S11') by an earthing/short-circuiting confirmation means (400) communicatively connected to the mobile communication device (1), and in the event of failed confirmation (S11') a fourth alarm signal is outputted (S9d) by the mobile communication device (1), and wherein the earthing/short-circuiting confirmation means (400) has an image recognition means and/or a clamping detection device for detecting clamping of a clamping means (EK) used for earthing and short-circuiting and/or a means for detecting fixed ball points of a ball head cover of the clamping means (EK).

13. Method according to either claim 11 or claim 12, wherein, after the earthing and short-circuiting of the electronic component (K1) are confirmed (S11), a work step instruction (A) for securing and blocking off adjacent voltage-carrying electronic components (K2, K3) is outputted (S12) by the work step sequence program, and subsequently the securing and blocking-off of adjacent voltage-carrying electronic components (K2, K3) is automatically or manually confirmed (S13; S13') at the mobile communication device (1).

14. Method according to claim 13, wherein the securing and blocking-off of adjacent voltage-carrying electronic components (K2, K3) is automatically confirmed (S13') by a securing/blocking-off confirmation means (500) communicatively connected to the mobile communication device (1), and in the event of failed confirmation (S13') a fifth alarm signal is outputted (S9e) by the mobile communication device (1), and wherein the securing/blocking-off confirmation means (500) has an image recognition means and/or a position detection means (LE) for a position of a barrier means (AS) used for the securing and blocking-off.

15. Method according to any of the preceding claims, wherein an article of safety equipment (SA) is provided for a user, a third bidirectional communication connection (F3) being established between the mobile communication device (1) and the article of safety equipment (SA), and wherein the mobile communication device (1) transmits at least one of the first to fifth alarm signals via the third bidirectional communication connection (F3) to the article of safety equipment (SA) to trigger an optical and/or acoustic warning means (AE) and/or vibration alarm means attached to the article of safety equipment (SA).

16. Method according to claim 15, wherein the article of safety equipment (SA) includes a safety jacket and/or a safety helmet and/or safety goggles and/or a safety coat and/or a safety overall and/or a shift jacket.

17. Method according to either claim 15 or claim 16, wherein the article of safety equipment (SA) includes a vitals sensor (VS), and the vital data of the user are transmitted via the third bidirectional communication connection (F3) to the mobile communication device (1).

18. Method according to claim 15, wherein the mobile communication device (1) is set up to establish a fourth unidirectional or bidirectional communication connection (F4) to a rescue centre (RZ) if critical vital data of the user are transmitted.

19. Method according to any of the preceding claims, wherein at least some of the work instructions, the associated confirmation or failed confirmation in each case, and the alarm signal in the event of a failed confirmation in each case are protocolled and stored in the mobile communication device (1).

20. Method according to any of the preceding claims, wherein the mobile communication device (1) comprises a smartphone or a laptop or tablet or smartglasses or a smartwatch.

21. Method according to any of the preceding claims, wherein a voltage test point confirmation means (10e) communicatively connected to the mobile communication device (1) is provided for confirming the voltage test point, the voltage test point being tested (S5a) by the voltage test point conformation means (10e) before the test result is communicated (S6), and the test result being communicated (S6) from the mobile voltage test means (10; 10') to the mobile communication device (1) only in the event of successful testing.

22. Method according to claim 21, wherein the voltage test point confirmation means (10e) has an image recognition means and/or has a sensor means integrated into the mobile voltage test means (10; 10').

23. Device for automatically monitoring an electrical engineering workflow, set up to carry out the method according to any of the preceding claims, comprising:
a mobile communication device (1), which has a first input means (1b), a first output means (1a), a first storage means (1c) and a first bidirectional communication interface (1d) ;
a work step sequence program stored on the mobile communication device (1);
a mobile voltage test means (10; 10'), which has a second input means (10c), a second output means (10a), a second storage means (10d) and a second bidirectional communication interface (10b);
wherein a first bidirectional communication connection (F1) can be established between the mobile communication device (1) and the mobile voltage test means (10; 10') via the first and second bidirectional communication interface (1d, 10b) .

24. Device according to claim 23, in particular for carrying out the method according to claim 8, further having an enabling confirmation means (200) which is communicatively connectable to the mobile communication device (1) and which has an image recognition means and/or a switching state reporting means (SM) of a voltage switch (S) to be actuated for the enabling and/or an electroluminescence measurement means for measuring an electric field at the electronic component (K1).

25. Device according to either claim 23 or claim 24, in particular for carrying out the method according to claim 10, further having a restart securing confirmation means (300) which is communicatively connectable to the mobile communication device (1) and which has an image recognition means and/or a blocking state reporting means for a lock (D) to be activated for securing against restart.

26. Device according to claim 23, 24 or 25, in particular for carrying out the method according to claim 12, further having an earthing/short-circuiting confirmation means (400) which is communicatively connectable to the mobile communication device (1) and which has an image recognition means and/or a clamping detection device for detecting clamping of a clamping means (EK) used for earthing and short-circuiting and/or a means for detecting fixed ball points of a ball head cover of the clamping means (EK).

27. Device according to any of claims 23 to 26, in particular for carrying out the method according to claim 14, further having a securing/blocking-off confirmation means (500) which is connectable to the mobile communication device (1) and which has an image recognition means and/or a position detection means (LE) for a position of a barrier means (AS) used for the securing and blocking-off.

28. Device according to any of claims 23 to 27 for carrying out the method according to claim 15, further having an article of safety equipment (SA) for a user, which comprises a third bidirectional communication interface (SK), and an optical and/or acoustic warning means (AE) and/or vibration alarm means attached to the article of safety equipment (SA), it being possible to set up a third bidirectional communication device (F3) between the mobile communication device (1) and the article of safety equipment (SA) via the first and third bidirectional communication interface (SK).

29. Device according to claim 28, wherein the article of safety equipment (SA) includes a safety jacket and/or a safety helmet and/or safety goggles and/or a safety coat and/or a safety overall and/or a shift jacket.

30. Device according to either claim 28 or claim 29, wherein the article of safety equipment (SA) includes a vitals sensor (VS).

31. Device according to any of claims 23 to 30, wherein the mobile communication device (1) comprises a smartphone or a laptop or tablet or smartglasses or a smartwatch.

32. Device according to any of claims 23 to 31, further comprising a voltage test point confirmation means (10e) communicatively connected to the mobile communication device (1) for confirming the voltage test point of the mobile voltage test means (10; 10'), which has an image recognition means and/or a sensor means integrated into the mobile voltage test means (10; 10').

33. Device according to any of claims 28 to 31, wherein the article of safety equipment (SA) has a sensor means configured to monitor the state, usage or maintenance of the article of safety equipment (SA) and to transmit this to the central stationary communication device (100) via the third bidirectional communication connection (SK).

## Revendications

1. Procédé de surveillance automatique d'un flux de travaux électrotechnique ayant une pluralité d'opérations, qui comporte les étapes suivantes de :
établir (S0) une première liaison de communication bidirectionnelle (F1) entre un appareil de communication mobile (1) et un détecteur de présence de tension mobile (10 ; 10') ;
lancer (S1) un programme de séquence d'opérations sur un appareil de communication mobile (1) au moyen d'un dispositif d'entrée (1b) de l'appareil de communication mobile (1),
générer (S2) une instruction d'opération (A) pour séparer un composant électronique sous tension (K1) pour entraîner une absence de tension du composant électronique (K1) sur un dispositif de sortie (1a) de l'appareil de communication mobile (1) par le programme de séquence d'opérations ;
confirmer automatiquement ou manuellement (S3 ; S3') la séparation du composant électronique (K1) sur l'appareil de communication mobile (1) ;
après la confirmation (S3 ; S3') de la séparation du composant électronique (K1), générer (S4) une instruction d'opération (A) pour vérifier l'absence de tension du composant électronique (K1) au moyen du détecteur de présence de tension mobile (10 ; 10') sur le dispositif de sortie (1a) de l'appareil de communication mobile (1) par le programme de séquence d'opérations ;
vérifier (S5) l'absence de tension du composant électronique (K1) au moyen du détecteur de présence de tension mobile (10 ; 10') ;
communiquer (S6) le résultat de vérification du détecteur de présence de tension mobile (10 ; 10') à l'appareil de communication mobile (1) ;
si le résultat de vérification indique une absence de tension, confirmer automatiquement (S8) la vérification de l'absence de tension du composant électronique (K1) en émettant un signal de confirmation par l'appareil de communication mobile (1) ;
si le résultat de vérification n'indique aucune absence de tension, générer (S9a) un premier signal d'alarme par l'appareil de communication mobile (1).

2. Procédé selon la revendication 1, dans lequel une deuxième liaison de communication bidirectionnelle (F2) est établie entre l'appareil de communication mobile (1) et un appareil de communication fixe central (100), et dans lequel le résultat de vérification du détecteur de présence de tension mobile (10 ; 10') est communiqué à l'appareil de communication fixe central (100).

3. Procédé selon la revendication 1 ou 2, dans lequel au moins un paramètre de vérification pouvant être enregistré dans le détecteur de présence de tension mobile (10 ; 10') peut être consulté et/ou réglé par l'appareil de communication mobile (1).

4. Procédé selon la revendication 3, dans lequel le paramètre de vérification comprend un réglage d'indication acoustique ou électronique et/ou une fonction supplémentaire et/ou un paramètre de données de consigne, en particulier une plage de mesure de tension, et/ou une capacité de batterie et/ou un temps de vérification obligatoire pour une vérification répétée et/ou une disponibilité opérationnelle du détecteur de présence de tension mobile (10 ; 10').

5. Procédé selon l'une des revendications précédentes, dans lequel l'appareil de communication mobile (1) comporte un dispositif d'enregistrement temporel et la vérification (S5) de l'absence de tension du composant électronique (K1) en utilisant le détecteur de présence de tension mobile (10 ; 10') est enregistrée sur la base du temps par le programme de séquence d'opérations et stocké dans l'appareil de communication mobile (1).

6. Procédé selon l'une des revendications précédentes, dans lequel l'appareil de communication mobile (1) comporte un dispositif de localisation GPS et la vérification (S5) de l'absence de tension du composant électronique (K1) en utilisant le détecteur de présence de tension (10 ; 10') est enregistrée sur la base de l'emplacement par le programme de séquence d'opérations et stocké dans l'appareil de communication mobile (1).

7. Procédé selon l'une des revendications précédentes, dans lequel l'appareil de communication mobile (1) comporte un dispositif de prévision météorologique et génère, dans le cas d'une prévision météorologique prédéterminée, en particulier d'une prévision d'orage, une indication d'avertissement dans le programme de séquence d'opérations.

8. Procédé selon l'une des revendications précédentes, dans lequel la confirmation (S3') de la séparation du composant électronique (K1) est exécutée automatiquement par un dispositif de confirmation de séparation (200) relié de manière communicante à l'appareil de communication mobile (1) et, en cas d'échec de confirmation (S3'), une sortie (S9B) d'un deuxième signal d'alarme est générée par l'appareil de communication mobile (1), et dans lequel le dispositif de confirmation de séparation (200) comporte un dispositif de reconnaissance d'image et/un dispositif d'indication d'état de commutation d'un commutateur de tension matériel et/ou logiciel (S) qui est actionné pour la séparation et/ou un dispositif de mesure d'électroluminescence pour mesurer un champ électrique sur le composant électronique (K1).

9. Procédé selon l'une des revendications précédentes, dans lequel, après la confirmation (S3 ; S3') de la séparation du composant électronique (K1) et avant de générer (S4) l'instruction d'opération (A) pour vérifier l'absence de tension du composant électronique (K1), une sortie (S3a) d'une instruction d'opération (A) est générée par le programme de séquence d'opérations afin de protéger le composant électronique (K1) contre tout réenclenchement, et une confirmation automatique ou manuelle (S3b ; S3b') de la protection du composant électronique (K1) contre tout réenclenchement est ensuite générée sur l'appareil de communication mobile (1).

10. Procédé selon la revendication 9, dans lequel la confirmation (S3b') de la protection du composant électronique (K1) contre tout réenclenchement est effectuée automatiquement par un dispositif de confirmation de protection contre tout réenclenchement (300) relié de manière communicante à l'appareil de communication mobile (300) et en cas d'échec de confirmation (S3b'), une sortie (S9c) d'un troisième signal d'alarme est générée par l'appareil de communication mobile (1), et dans lequel le dispositif de confirmation de protection contre tout réenclenchement (300) comporte un dispositif de reconnaissance d'image et/ou un dispositif d'indication d'état de blocage d'un verrou (D) qui doit être actionné pour protéger contre tout réenclenchement.

11. Procédé selon l'une des revendications précédentes, dans lequel, si le résultat de vérification indique une absence de tension et si le signal de confirmation est généré par l'appareil de communication mobile (1), une sortie (S10) d'une instruction d'opération (A) pour la mise à la terre et la mise en court-circuit du composant électronique (K1) est générée par le programme de séquence d'opérations, puis une confirmation automatique ou manuelle (S11 ; S11') de la mise à la terre et de la mise en court-circuit du composant électronique (K1) sur l'appareil de communication mobile (1) .

12. Procédé selon la revendication 10, dans lequel la confirmation (S11') de la mise à la terre et de la mise en court-circuit du composant électronique (K1) est générée automatiquement par un dispositif de confirmation de mise à la terre/en court-circuit (400) relié de manière communicante à l'appareil de communication mobile (1) et en cas d'échec de confirmation (S11'), une sortie (S9d) d'un quatrième signal d'alarme est générée par l'appareil de communication mobile (1) et dans lequel le dispositif de confirmation de mise à la terre/en court-circuit (400) comporte un dispositif de reconnaissance d'image et/ou un dispositif de détection de serrage pour détecter un serrage d'un dispositif de serrage (EK) utilisé pour la mise à la terre et la mise en court-circuit et/ou un dispositif pour détecter des points sphériques fixes d'une tête sphérique du dispositif de serrage (EK).

13. Procédé selon la revendication 11 ou 12, dans lequel après la confirmation (S11) de la mise à la terre et de la mise en court-circuit du composant électronique (K1), une sortie (S12) d'une instruction d'opération (A) est générée par le programme de séquence d'opérations pour protéger et séparer par barrière des composants électroniques sous tension adjacents (K2, K3), et une confirmation automatique ou manuelle (S13 ; S13') de la protection et de la séparation par barrière de composants électroniques sous tension adjacents (K2, K3) est ensuite générée sur l'appareil de communication mobile (1).

14. Procédé selon la revendication 13, dans lequel la confirmation (S13') de la protection et de la séparation par barrière de composants électroniques sous tension adjacents (K2, K3) est effectuée automatiquement par un dispositif de confirmation de protection/séparation par barrière (500) relié de manière communicante à l'appareil de communication mobile (1) et en cas d'échec de confirmation (S13'), une sortie (S9e) d'un cinquième signal d'alarme est générée par l'appareil de communication mobile (1) et dans lequel le dispositif de confirmation de protection/séparation par barrière (500) comporte un dispositif de reconnaissance d'image et/ou un dispositif de détection de position (LE) d'une position d'un dispositif de barrière (AS) utilisé pour la protection et la séparation par barrière.

15. Procédé selon l'une des revendications précédentes, dans lequel un équipement de protection (SA) est prévu pour un utilisateur, dans lequel une troisième liaison de communication bidirectionnelle (F3) est établie entre l'appareil de communication mobile (1) et l'équipement de protection (SA), et dans lequel l'appareil de communication mobile (1) transmet au moins un des premier à cinquième signaux d'alarme via la troisième liaison de communication bidirectionnelle (F3) à l'équipement de protection (SA) afin de déclencher un dispositif d'avertissement (AE) optique et/ou acoustique et/ou un dispositif d'alarme par vibration fixé sur l'équipement de protection (SA).

16. Procédé selon la revendication 15, dans lequel l'équipement de protection (SA) comporte une veste de protection et/ou un casque de protection et/ou des lunettes de protection et/ou un manteau de sécurité et/ou une combinaison de protection et/ou un manteau de protection.

17. Procédé selon la revendication 15 ou 16, dans lequel l'équipement de protection (SA) comporte un capteur de sens vitaux (VS) et les données vitales de l'utilisateur sont transmises à l'appareil de communication mobile (1) via la troisième liaison de communication bidirectionnelle (F3) .

18. Procédé selon la revendication 15, dans lequel l'appareil de communication mobile (1) est conçu pour établir, en cas de transmission de données vitales critiques de l'utilisateur, une quatrième liaison de communication unidirectionnelle ou bidirectionnelle (F4) avec un centre de secours (RZ).

19. Procédé selon l'une des revendications précédentes, dans lequel au moins une partie des instructions de travail, la confirmation respective associée ou l'échec de confirmation et le signal d'alarme respectif en cas d'échec de confirmation, sont enregistrés et stockés dans l'appareil de communication mobile (1).

20. Procédé selon l'une des revendications précédentes, dans lequel l'appareil de communication mobile (1) comprend un téléphone intelligent ou un ordinateur portable ou une tablette ou des lunettes intelligentes ou une montre intelligente.

21. Procédé selon l'une des revendications précédentes, dans lequel un dispositif de confirmation de point de détection de tension (10e) relié de manière communicante à l'appareil de communication mobile (1) est prévu pour confirmer le point de détection de tension, dans lequel avant la communication (S6) du résultat de vérification, un contrôle (S5a) du point de détection de tension est effectué par le dispositif de confirmation de point de détection de tension (10e) et dans lequel la communication (S6) du résultat de vérification du détecteur de présence de tension mobile (10 ; 10') à l'appareil de communication mobile (10) est uniquement réalisée en cas de contrôle réussi.

22. Procédé selon la revendication 21, dans lequel le dispositif de confirmation de point de détection de tension (10e) comporte un dispositif de reconnaissance d'image et/ou un dispositif de capteur intégré dans le détecteur de présence de tension mobile (10 ; 10').

23. Dispositif de surveillance automatique d'un flux de travaux électrotechnique, conçu pour la mise en œuvre du procédé selon l'une des revendications précédentes, comportant :
un appareil de communication mobile (1) qui comporte un premier dispositif d'entrée (1b), un premier dispositif de sortie (1a), un premier dispositif de stockage (1c) et une première interface de communication bidirectionnelle (1d) ; un programme de séquence d'opérations stocké sur l'appareil de communication mobile (1) ;
un détecteur de présence de tension mobile (10 ; 10') qui comporte un second dispositif d'entrée (10c), un second dispositif de sortie (10a), un second dispositif de stockage (10d) et une deuxième interface de communication bidirectionnelle (10b) ;
dans lequel une première liaison de communication bidirectionnelle (F1) peut être établie entre l'appareil de communication mobile (1) et le détecteur de présence de tension mobile (10 ; 10') via les première et deuxième interfaces de communication bidirectionnelle (1d, 10b).

24. Dispositif selon la revendication 23, en particulier pour la mise en œuvre du procédé selon la revendication 8, comportant en outre un dispositif de confirmation de séparation (200) pouvant être relié de manière communicante à l'appareil de communication mobile (1), lequel dispositif de confirmation comporte un dispositif de reconnaissance d'image et/ou un dispositif d'indication de commutation (SM) d'un commutateur de tension (S) qui doit être actionné pour 1 la séparation et/ou un dispositif de mesure d'électroluminescence pour mesurer un champ électrique sur le composant électronique (K1).

25. Dispositif selon la revendication 23 ou 24, en particulier pour la mise en œuvre du procédé selon la revendication 10, comportant en outre un dispositif de confirmation de protection contre tout réenclenchement (300) pouvant être relié à l'appareil de communication mobile (1), lequel dispositif de confirmation comporte un dispositif de reconnaissance d'image et/ou un dispositif d'indication d'état de blocage d'un verrou (D) qui doit être actionné pour la protection contre tout réenclenchement.

26. Dispositif selon la revendication 23, 24 ou 25, en particulier pour la mise en œuvre du procédé selon la revendication 12, comportant en outre un dispositif de confirmation de mise à la terre/en court-circuit (400) pouvant être relié à l'appareil de communication mobile (1), lequel dispositif de confirmation comporte un dispositif de reconnaissance d'image et/ou un dispositif de détection de serrage pour détecter un serrage d'un dispositif de serrage (EK) utilisé pour la mise à la terre et la mise en court-circuit et/ou un dispositif de détection de points sphériques fixes d'une tête sphérique du dispositif de serrage (EK).

27. Dispositif selon l'une des revendications 23 à 26, en particulier pour la mise en œuvre du procédé selon la revendication 14, comportant en outre un dispositif de confirmation de protection/séparation par barrière (500) pouvant être relié à l'appareil de communication mobile (1), lequel dispositif de confirmation comporte un dispositif de reconnaissance d'image et/ou un dispositif de détection de position (LE) d'une position d'un dispositif de barrière (AS) utilisé pour la protection et la séparation par barrière.

28. Dispositif selon l'une des revendications 23 à 27 pour la mise en œuvre du procédé selon la revendication 15, comportant en outre un équipement de protection (SA) pour un utilisateur avec une troisième interface de communication bidirectionnelle (SK) et un dispositif d'avertissement optique et/ou acoustique (AE) et/ou un dispositif d'alarme par vibration monté sur l'équipement de protection (SA), dans lequel une troisième liaison de communication bidirectionnelle (F3) peut être établie entre l'appareil de communication mobile (1) et l'équipement de protection (SA) via les première et troisième interfaces de communication bidirectionnelle (SK).

29. Dispositif selon la revendication 28, dans lequel l'équipement de protection (SA) comporte une veste de protection et/ou un casque de protection et/ou des lunettes de protection et/ou un manteau de sécurité et/ou une combinaison de protection et/ou un manteau de protection.

30. Dispositif selon la revendication 28 ou 29, dans lequel l'équipement de protection (SA) comporte un capteur de sens vitaux (VS).

31. Dispositif selon l'une des revendications 23 à 30, dans lequel l'appareil de communication mobile (1) comprend un téléphone intelligent ou un ordinateur portable ou une tablette ou des lunettes intelligentes ou une montre intelligente.

32. Dispositif selon l'une des revendications 23 à 31, comprenant en outre un dispositif de confirmation de point de détection de tension (10e) pouvant être relié à l'appareil de communication mobile (1) pour confirmer le point de détection de tension du détecteur de présence de tension mobile (10 ; 10') qui comporte un dispositif de reconnaissance d'image et/ou un dispositif de capteur intégré dans le détecteur de présence de tension mobile (10 ; 10').

33. Dispositif selon l'une des revendications 28 à 31, dans lequel l'équipement de protection (SA) comporte un dispositif de capteur qui est configuré pour surveiller l'état, l'utilisation ou l'entretien de l'équipement de protection (SA) et pour le transmettre à l'appareil de communication fixe central (100) via la troisième liaison de communication bidirectionnelle (SK).
